(19) Europäisches Patentamt
European Patent Office
Office européen des brevets

(11) EP 0 715 343 A1

(12) **EUROPEAN PATENT APPLICATION**
published in accordance with Art. 158(3) EPC

(43) Date of publication:
**05.06.1996 Bulletin 1996/23**

(21) Application number: **94924391.9**

(22) Date of filing: **19.08.1994**

(51) Int. Cl.$^6$: **H01L 21/28**

(86) International application number:
**PCT/JP94/01373**

(87) International publication number:
**WO 95/06329 (02.03.1995 Gazette 1995/10)**

(84) Designated Contracting States:
**CH DE FR GB IT LI NL**

(30) Priority: **20.08.1993 JP 206741/93**
**02.09.1993 JP 218889/93**
**19.11.1993 JP 290786/93**

(71) Applicant: **OHMI, Tadahiro**
**Sendai-shi Miyagi-ken 980 (JP)**

(72) Inventors:
- **OHMI, Tadahiro**
  **Sendai-shi Miyagi-ken 980 (JP)**
- **YAMADA, Keiichi**
  **Department of Electronics Faculty**
  **Aoba-ku Sendai-shi Miyagi-ken 980 0 (JP)**

(74) Representative: **Weitzel, Wolfgang, Dr.-Ing.**
**Patentanwalt**
**Friedenstrasse 10**
**89522 Heidenheim (DE)**

(54) **SEMICONDUCTOR DEVICE AND ITS MANUFACTURE**

(57) An object of the present invention is to provide a semiconductor device in which a contact resistance between an electrode and a semiconductor is reduced, and contact and structure between a semiconductor comprising a minute and extremely shallow and thin layer and an electrode and a method of manufacturing the same.

At least one metallic layer and a semiconductor are continuously formed on a surface of a semiconductor without being exposed to the atmospheric air, a heat processing is executed thereto to react said metallic layer with said semiconductor for forming a compound of a metal and a semiconductor. Furthermore the present invention is characterized in that ion implantation is executed prior to heat processing. Also in the semiconductor device with a compound of said semiconductor and a metal formed in a contact section between the semiconductor and the electrode according to the present invention, a depth of an interface between said compound and said semiconductor is less than 22 nm, or a half of a thickness of said compound or more is positioned above a surface of said semiconductor.

Furthermore if there is provided a multi-layered metallic wiring construction, a thin silicide layer is provided on a contact section for connecting the upper and lower metallic wirings.

Fig. 1

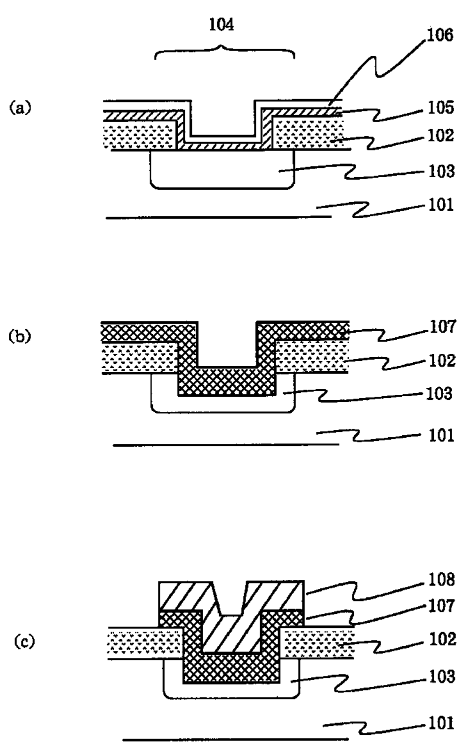


EP 0 715 343 A1

## Description

### FIELD OF THE INVENTION

The present invnetion relates to a method of manufacturing a semiconductor device, and more particularly to a semiconductor device suited to a ultra-high large scale integrated circuit (ULSI) and the manufacturing method.

### BACKGROUND TECHNOLOGY

At present, an integration desgree in an ULSI has been becoming increasingly higher and higher, and not active efforts are made for research and development to realize a ultra minute element having a size of 0.1 μm or less.

Because of increase in the integration degree of elements, there is now also a tendency for more complicated and more multi-layered wiring construction. In association with the tendency a number of contact sections between wirings or between metalic wiring and a semiconductor has been explosively increasing, and in addition, the size has been made smaller and smaller. Realization of high reliability as well as high performance of various types of contact existing in a ULSI is an important item in development, which is a key for realization of high reliability and high performance ULSIs.

To achieve the high reliability and high performance of a contact section between a metal component and a semiconductor, it is essential to lower resistance in the contact section, and for its realization, formation of a ultra-clean contact interface is indispensable. For, if an insulating material layer (such as an oxide film etc.), which hinders electric conductivity on a contact interface, exists, increase of resistance in the contact section and non-uniformity of resistance value in the contact section are caused.

It is extremely difficult to obtain a ultra-clean contact interface in a case of contact between metallic wirings or in a case where a metalic component for forming an ohmic contact electrode of a semiconductor element and a semiconductor. For, to form a contact, it is required to provide a material for forming an electrode on a surface of a material, which is easily oxidized, such as a surface of a metal component or that of a component obtained by adding impurities at a high density into a semiconductor, and an oxide film easily remains on the interface formed as described above. For instance, in a case of a surface of a metal component, an oxide film having a thickness from 2 to 5 nm is formed only by exposing the surface to atmospheric air for several seconds, and in a case of an $n^+$-Si surface, an $SiO_2$ film having a thickness form 0.5 to 1 nm is formed only by washing it with ordinary ultra pure water. It can easily be understood from the facts described above how technologically difficult it is to realize a contact interface without any oxide film existing thereon under stable conditions. For this reason, it is extremely important to establish a technology for forming a ultra-clean contact interface between a metallic component and a semiconductor in an ULSI manufacturing technology.

Conventionally, in forming a contact, heat processing has been executed after formation of a contact electrode material as a possible solution for contamination existing on an interface as described above, especially for growth of an oxcide film. In forming a junction between a metal component and a silicon, such technology that silicide with a metal having a high melting point is formed and contact resistance is reduced has been developed. Heat processing is executed after formation of a thin film made of metal having a high melting point on a silicon to form a silicide compound, and an interface between a silicide and a silicon is brought to a position deeper than that of the interface immediately after forming the contact, which makes it possible to obtain a clean interface between a silicide and Si. Further, for forming a silicide under the stable conditions, or for the purpose of lowering a temperature required for converting it to silicide, technology for forming silicide by using ion beam mixing has been developed. The technology described above is one on which a silicide is formed by forming a film with metal having a high melting point on the silicon, by carrying out ion implantation thereto through the surface of the film, and then by executing heat processing thereto.

However, there have been some problems to be solved in these methods of forming a contact between a metal compound and a semiconductor by forming a silicide.

Description is made for some problems relating to a conventional technology with reference to Figs.10 to 12 by taking up a case where a Ta silicide electrode is formed on $n^+$-Si as an example. Fig.10 is a cross-sectional view showing a forming process of a Ta silicide electrode on $n^+$-Si. In Fig.10 (a), the reference numeral 1001 indicates a p-type silicone wafer, and the specific resistance is in a range from 0.3 to 1.0 Ω · cm. On the surface of the wafer, a SiO2 film 1002 having a thickness of around 500 nm is formed as an insulating film. On a portion of the suface thereof, an n+ high density layer 1003 in which a density of n-type impurities is 2 x $10^{20}$ $cm^{-3}$ is formed, and at least one opening section 1004 is provided on the $SiO_2$ 1002 so that a portion of an area in the high density layer 1003 can be electrically communicated to the outside. On the layer, a Ta layer 1005 having a thickness of around 10 nm is formed. The heat processing is carried out to the wafer having the construction described above to form a silicide layer($TaSi_2$) 1006 (Refer to Fig.10(b)). As a method of heat processing, an electric furnace is used, and a flow rate of an Ar gas is set to 21/min, and then annrealing is executed for 1 hour under a temperature of 900 °C. A Ta layer 1007 having a thickness of around 500 nm is formed thereon as a material for lead wiring, then patterning is executed thereto (Refer to Fig.10(c)).

Fig.11 shows a result of meansurement of the contact resistance of the $TaSi_2$/$n^+$-Si formed according to the manufacturing process. The result indicates that the resistance value and a range of dispersion in the value are not sufficient to realize a high performance ULSI.

It is required that contact resistance of metal semiconductors such as a source in a MOS transistor and an emitter in a bipolar transistor is completely small. If resistance Rs of the source or emitter is larger, a current I flowing a transistor can not be made larger, and for this reason a high speed operation of the LSI is not possibly realized. If resistance Rs exists in the source or emitter, a voltage Vgi added to an intrinsic transistor becomes $Vgi = Vg - RsI$ , and as a result, the voltage becomes smaller by RsI than the control voltage Vg loaded from the outside. Assuming that gm indicates converting conductance of a transistor, the following expression is obtained: $I = gm(Vg - RsI)$ , and then the following expressing is obtained according to the expression described above: $I = gmVg/(1 + gmRs)$ , and if the Rs is larger, the denominator becomes larger which makes a current I extremely smaller. For instance, when an area of a contact hole is $0.1 \times 0.1\ \mu m^2$ ($= 10^{-10} cm^2$), only one unit of contact makes contact resistance of 1 KΩ in the contact resistance $Rc = 1 \times 10^{-7} \Omega cm^2$ based on the conventional type. Generally, in a case of a CMOS construction, 4 units of contact are put into between the power supply unit and a ground, so that it is indispensable that the Rc is set to $1 \times 10^{-9} \Omega cm^2$ or less.

Fig.12 shows a result of measuring an impurities density distribution in the depth direction for the Ta $Si_2/n^+$-Si junction formed in the manufacturing process described above by means of a secondary ion mass spectrometry (SIMS). Although cleanliness of the interface between a silicide and a Si can be realized in some degree based on the techology described above, it is understood that oxygen existed on the interface in the initial stage has been fetched into a silicide layer, which becomes one of the causes to increase the resistance. If an oxide was formed on the metallic surface before the heat processing was executed thereto, it was observed that the oxygen was mixed into the silicide layer during heat processing, which causes the formed silicide layer to increase.

Furthermore there is a problem that a silicide layer is engaged into a silicon substrate as a crucial problem in the electrode forming process in which a method of converting the layer to silicide based on the conventional technology is used.

In a silicide reaction between a metal having a high melting point and a silicon, the silicide layer intrudes deeply into the silicone layer, so that it is quite difficult to achieve extremely shallow junction between a silicide and a silicon.

Fig.13 shows a result of studying how the silicide layer engages into the silicon substrate taking up a case of forming a tantalum silicide ($TaSi_2$) by means of reaction of Ta on silicon as an example. When a film of Ta having a thickness of 10 nm is formed on the silicon substrate and is reacted on the silicon substrate by executing the heat processing, a tantalum silicide layer having a thickness of 24 nm is formed on the surface of silicon substrate. Assuming that Ta in the initial stage and a silicon interface are regarded as a reference, the silicide layer is engaged into a position which is 22 nm in depth. It is understood that more than 90 % of the film thickness of the formed silicide is sunk in the silicon substrate. Therefore, great distortion is locally generated because of difference of lattice gaps between Si and silicide, which causes some defects and generation of transfer. Accordingly, the electrode forming method in which a method of converting the layer to silicide based on the conventional technology is used limits the construction of an element to be used for forming an electrode of a semiconductor element including therein an extremely thin as well as an extremely shallow junction.

In accordance with developement of ultrafine/ultrahigh integration of the ULSI, a junction in a semiconductor, such as a source as well as a drain in a MOSFET and emitters in a bipolar transistor becomes extremely shallower and shallower to have reached up to 10 to 50 nm. In a case where the process of convert a metallic thin film and a silicon to silicide is used for a process for forming an ohmic contact electrode to a semiconductor having such an extremely shallow depth of junction, there is a possibility that the silicide layer may penetrate the ultra thin layer such as the source/drain and emitter in the forming method based on the conventional technology.

Determining from the fact described above, the technology for forming a silicide based on the conventional type thereof is not thought to be a perfect solution for complete reduction of contact resistance,and furthermore some problems to extremely shallow depth of the junction occur, which makes it substantially difficult to achieve high performance and high reliability of the ULSI.

It is a main object of the present invention to realize two important items indispensable in a process for forming an electrode and wiring in a semiconductor device for a high performance and high reliability ULSI. One of them is to eliminate, for reduction of contact resistance between an electrode section and a semiconductor layer, a contaminated layer comprising mainly an oxide film and to form a contact construction between a high quality metal component and a semiconductor,in which a density of impurities in the semiconductor layer in an area of around 1 nm close to the interface between the metal layer and semicondocter layer, namely a density of electrons and a density of holes are made to a maximum level, and the other object is to form a contact construction between a metal component and a semiconductor for a semiconductor device having an extremely shallow as well as extremely thin layer.

## DESCLOSURE OF THE INVENTION

The method of manufacuring the semiconductor device according to the present invention is obtained by continuously forming at least one layer of metal layer and semiconductor layer without being exposed to the atmospheric air on at least a portion of the surface of semiconductor, and then heat processing is carried out and the metal layer is reacted on the semiconductor to form a compound from the metal and the semiconductor.

Further, before the heat processing, it is preferable to executing ion implantation of a specified atoms of impurities or molecules of impurities to the semiconductor via the semiconductor layer or metal layer, and elements constituting the semiconductor, or atoms generating electrones or holes in the semiconductor, or molecules including the atoms described above are preferable, and the implanted rate is preferably in a range from 1 x $10^{13}$ to 4 x $10^{18}$ $cm^{-2}$.

Furthermore, it is preferable that the metal layer is a metal having a high melting point including at least one among Ta, Ti, W, Co, Mo, Hf, Ni, Zr, Cr, V, Pd, and Pt, an alloy including metals having a high melting point, or a compound of metals having a high melting point, and a thickness of the film is preferably in a range from 1 to 50 nm.

In the semiconductor layer, it is preferable that a density of iimpurities is 1 x $10^{18}$ $cm^{-3}$ or less, which is the density in which the surface thereof is not instantly oxidized even if the surface is exposed to the atmospheric air or is washed with ultra pure water. A thickness of the film is preferably 0.3 nm or more. Furthermore, it is preferable that a thickness of the semiconductor is made thicker than that of the metal layer.

Furthermore, it is preferable that the semiconductor and semiconductor layer are silicon semiconductors.

In the present invention, after the heat processing, in a case where there exists a semiconductor not reacted yet when a second metal layer is further formed, the unreacted semiconductor is removed to form the second metal layer,or the heat processing is executed after forming the second metal layer on the unreacted semiconductor layer to form a compound from the unreacted semiconductor layer and a metal of the second metal layer.

In the method of manufacuturing the semiconductor device according to the present invention, a metal layer and a semiconductor layer are continuously formed on the substrate without being exposed to the atmospheric air, then the heat processing is carried out and the metal layer is reacted on the semiconductor layer to form a compound from the metal and the semiconductor, and after the step, the unreacted metal layer is removed by etching to form a compound from the metal and semiconductor to a specified shape.

The semiconductor device according to the present invention is manufactured by the manufacturing method described above.

In the semiconductor device in which a compound from the semiconductor and metal is formed in the contact section between a semiconductor and an electrode, the depth of interface between the compound and the semiconductor is made shallower than 22 nm.

Further, in the semiconductor device according to the present invention in which a compound of the semiconductor and metal is formed in the contact section between a semiconductor and an electrode, more than a half portion of the thickness of the compound is positioned in the upper side from the surface of the semiconductor.

And furthermore, in the semiconductor device according to the present invention having a construction of multi-layered metallic wiring, the contact section in which metallic wirings in the upper side and the lower side are connected to each other has a thin silicide layer.

FUNCTION

In the present invention, in forming a junction between metallic wirings or an electorde material and a semicondutor, an ultra clean surface made with a metal which is very easily oxidized is covered with the semiconductor layer to prevent the surface from contamination such as growth of an oxcide film, the heat processing is carried out to form a compound from the metal and semiconductor. With this feature, it is possible to form a junction between an electrode and a semiconductor without existance of an oxide film thereon, and also to form an electrode layer which has little impurities such as oxygen and has small resistance. Also, at the same time, a metal and a semiconductor are reacted on each other by holding the top and bottom sides of metal layer with semiconductors, so that semiconductors required for the reaction can be supplied from both the top and bottom sides of the metal. With this feature, when the entire metal layer is reacted, a depth of engagement of the compound layer from the metal and semiconductor into the semiconductor can be made shallower. Especially, by making a thickness of the semiconductor layer thicker than that of the metal layer, the engagement thereinto can be made further shallower. It should be noted that, in the present invention, a semiconductor layer is preferably the same type of material as that of the semiconductor, but the same effect as described above can be obtained even it is made with other types of material.

Further, it is also effective for improvement of characteristics such as reduction of contact resistance to execute ion implantation close to the interface between the metal layer and semiconductor by transmitting the metal layer and semiconductor layer before the heat processing. With ion implantation, a metal and a semiconductor are mixed, which makes it possible to reduce a temperature and a period of time required for the heat processing to form a compound. As a species of ions to be implanted, to further reduce contact resistance and again crystalize a semiconductor, a dopant for a semiconductor, semiconductor construction elements, and elements constituting a metal layer are preferably used. Especially, conditions for manufacturing process are controlled by using ions to become a dopant so that a dopant density becomes a maximum level on the final interface section between the compound layer from a metal and a semiconductor and the semiconductor, which makes it possible to reduce contact resistance between a metal and a semiconductor. The ion implanted rate and the ion energy are decided depending on a species of ions to be implanted, conditions of heat processing, film thickness of a semiconductor layer and of a metal layer, and elements thereof as required, but to further reduce the contact resistance and again crystalize a semiconductor, a range from 1 x $10^{13}$ to 4 x $10^{18}$ $cm^{-2}$, and a range from 16 to 200 KeV are preferable respectively. And also an implanted rate is preferably in a range from 1 x $10^{15}$ to 1 x $10^{17}$ $cm^{-2}$.

In the manufacturing method according to the present invention, Si and Ge are suitably used as a semiconductor and a semiconductor layer, and Ta, Ti, W, Co, Mo, Hf, Ni, Zr, Cr, V, Pd, Pt or the like as a metal layer. Especially, in a case where Si as a material for a semiconductor and metals having a high melting point such as Ta, Ti, W, Pt or the like as a metal material are selected, they are suitably applied thereto, which becomes a very promising manufacturing method as a manufacturing method enabling further high performance of an LSI.

A film thickness of a semiconductor layer and of a metal layer is decided depending on conditions of ion implantation, conditions of heat processing, and the pouposes of the usage thereof in association with the relation among them to each other. A film thickness suitable for a semiconductor is 0.3 nm or more. Also the thickness for a metal layer is preferably in a range from 1 to 50 nm. If a thickness thereof is made to 1 nm or more, a further more uniform compound from a metal and a semiconductor can be formed, and if it is 50 nm or less, it is possible to suppress generation of defects in a crystal at formation of the compound. Furthermore, in the present invention, a density of impurities in a semiconductor layer is preferably made to 1 x $10^{18}$ $cm^{-3}$ or less, the resistance of the compound generated in this range can be made furthermore smaller. Because the surface of a semiconductor layer can easily be oxidized when exposed to the atmospheric air if a density of impurities in the semiconductor layer becomes higher than this value.

In the heat processing according to the present invention, the temperature is preferably 100°C or more, and more preferably in a range from 300 to 500°C. A compound from a metal and a semiconductor having small resistance and small contact resistance is formed in this range.

In the present invention, a metal layer and a semiconductor layer are continuously formed on the substrate without being exposed to the atmospheric air, then heat processing is carried out and the metal layer and semiconductor layer are reacted on each other to form a compound from a metal and a semiconductor, and then unreacted metal layer is removed by etching, and the compound from the metal and semiconductor is formed to a specified shape, so that it is possible to precisely and finely execute patterning to a metale haivng a high melting point and the compound (silicide or the like) on which it is used to be difficult to form a fine pattern based on the conventional techonology.

BRIEF DESCRIPTION OF THE DRAWINGS

Fig.1 is a concept view showing a first embodiment according to the present invention, which shows sequential processes for a manufacturing method of an ohmic contact electrode to high density sylicon according to a silicide electrode.

Fig.2 is a graph showing contact resistance between the electrode and the semiconductor according to Embodiment 1.

Fig.3 is a graph showing an impurities density distribution in the depth direction in the electrode construction according to Embodiment 1.

Fig.4 is a concept view showing a second embodiment according to the present invention, which shows sequential processes for the manufacturing method of a pn-junction diode construction.

Fig.5 is a graph showing current-voltage characteristics of the diode in Embodiment 2.

Fig.6 is a concept view showing a third embodiment according to the present invention, which shows sequential processes for the manufacturing method of junction construction having a very shallow depth between a silicide and a semiconductor.

Fig.7 is a concept view showing a fouth embodiment according to the present invention, which shows sequential processes for the manufacturing method of a multi-layered wiring construction having high reliability.

Fig.8 is a concept view showing a fifth embodiment according to the present invention, which shows sequential processes for the manufacturing method of an electrode as well as wiring form by means of formation of silicide.

Fig.9 is a concept view showing a sixth embodiment according to the present invention, which shows sequential processes for the manufacturing method of a silicide electrode as well as wiring construction in which the depth of junction between a silicide and a silicon is extremely shallow and at the same time high reliability thereof is achieved.

Fig.10 is a concept view showing a contact between an electrode and a semiconductor based on the conventional technology.

Fig.11 is a graph showing contact resistance between an electrode and a semiconductor based on the conventional technology.

Fig.12 is a graph showing an impulities density distribution in the depth direction in an electrode construction based on the conventional technology;

Fig.13 is a concept view showing the depth of a junction surface between a silicide and a silicon in the conventional technology.

Fig.14 is a concept view showing another example of the multi-layered wiring construction according to the present invention.

Fig.15 is a concept view showing another example of the multi-layered wiring construction according to the present invention.

Fig.16 is a concept view showing another example of the multi-layered wiring construction according to the present invention.

(Description of the reference numerals)

101 semiconductor, 102 insulating layer,
103 high density semiconductor layer,
104 opening section, 105 metal layer,
106 semiconductor layer,
107 compound layer formed from a semiconductor and a metal,
108 metal layer,
403 high density semi-conductor layer,
407 compound layer formed from a semiconductor and a metal,
408 metal layer, 601 semiconductor,
602 insulating layer, 603 opening section,
604 metal layer, 605 semiconductor layer,
606 compound layer formed from a semiconductor and a metal, xj depth of a junction, 701 semiconductor,
702 insulating layer, 703 opening section,
704 metal layer, 705 semiconductor layer,
706 compound layer formed from a semiconductor and a metal,
707 insulating layer,
708 opening section, 709 metal layer,
710 compound layer formed from a semiconductor and a metal,
711 metal layer, 801 semiconductor,
802 insulating layer, 803 opening section,
804 metal layer, 805 semiconductor layer,
806 compound layer formed from a semiconductor and a metal,
901 semiconductor,
902 insulating layer,
903 high density semiconductor layer,
904 opening section,
905 -1, -2, -3, -4 metal layer,
906 -1, -2, -3, -4 semiconductor layer,
907 compound layer formed from a semiconductor and a metal,
1001 semiconductor,
1002 insulating layer,
1003 high density-semiconductor layer,
1004 opening section, 1005 metal layer,
1006 compound layer formed from a semiconductor and a metal,
1007 metal layer,
1401,1404 interlayer insu-lating films,
1402 first Al alloy wiring,
1403,1407,1408 non-dope Si layer,
1405 selective growth Tangusten (W), and
1406 second Al alloy wiring.

BEST MODE FOR CARRYING OUT THE INVENTION

Next detailed description is made for embodiments of the present invention.

(Embodiment 1)

At first, description is made for First embodiment of the present invetion with reference to Fig. 1. Figs.1(a) to 1(c) are cross-sectional views each showing a process for forming an ohmic contact electrode by applying Ta silicide onto $n^+$-Si.The reference numeral 101 indicates, for instance, a p-type silicon wafer, and the specific resistance is in a range from 0.3 to 1.0 $\Omega \cdot cm$. The wafer may be an n-type one, if required. On a surface of a wafer, for instance, an $SiO_2$ film 102 having a thickness of around 500 nm is formed on an insulating film. On a wafer's surface, a high density $n^+$ layer 103, in which a density of n type impurities is, for instance, in a range from 1 to 2 x $10^{20}$ $cm^{-3}$, is formed, and an opening section 104 is provided on the $SiO_2$ film 102 so that a portion of an area of the high density layer 103 is electrically communicated to the outside. Formed on the opening section 104 is an electrode material layer 105 (for instance, a Ta layer) having a thickness from around 5 to 50 nm. Forthermore on the Ta layer 105, an Si layer 106 including impurities having the specific resistance in a range, for instance, from 0.01 to 10 $k\Omega \cdot cm$ at an extremely low density (in a range from 1 x $10^{12}$ to 1 x $10^{15}$ $cm^{-3}$) is formed in a range from around 2 to 30 nm. The Ta layer and Si layer are continuously formed without being exposed to the atmospheric air using a thin film forming device compatible with a high degree of vacuum. It is necessary to continuously form the layers because, if metal is exposed to the atmospheric air, the surface is instamaticly oxidized in a thickness from 2 to 5 nm. Especially when anon-dope Si film is formed on the Ta layer, the layer's surface is not oxidized for around 1 hour ven if it is exposed to the atmospheric air. It is needless to say that, if required for a specific purpose or under specific conditions, metal other than Ta may be used, and any thickness of a layer may be selected. Also for the Si layer, the thickness mau freely be specified according to the purpose or conditions (Refer to Fig.1(a). A schottky barrier height of Ta for n-Si and p-Si is 0.56 eV and 0.58 eV respectively and is substantially equalt for the two types, so that an extremely low contact resistance is realized in $n^+$-Si and $p^+$-Si respectively. Ti is another metal having the similar characteristics.

Ion implantation was carried out to a wafer having the construction as described above. As a species of ions to be implanted, impurities which become the same type as the high density layer 103 on the wafer, such as As ions, are implanted. Also P or Sb ions may be used for the same purpose, but when integrity of the crystal structure is taken into considerations, the same element as impurities in the high density layer 103 should desirably be used. The implanted dose rae is, for instance, 2

x $10^{15}$ $cm^{-2}$, and an acceleration energy for ions was set, for instance, to 75 keV.

In this embodiment, a density of impuritieson an interface between the silicide and an Si semiconductor was set to the maximum level and also As ions were used to furthermore lowe the contact resistance, but other ions (such as Ta or Si ions etc.) may be used in a case where the object is only for ion mixing.

After ion implantation, heat processing was executed to form a silicide layer ($TaSi_2$) 107 and again crystalize the ion-implanted layer. As a method of heat processing, an electric furnace was used, and annealing was executed for 1 hour under a temperature of 900°C flowing Ar gas at a rate of 2l/min. Heating method may be executed with a lamp or according to any other method. The temperature required for heating is not always limited to 900°C, and the temperature in a range from 400 to 500°C may be allowable for this purpose. Also the gas available for this purpose is not limited to Ar, and such gases as $H_2$, $N_2$, He or a mixture thereof may be used according to a particular purpose or under specific conditions, and also the flow rate is not always limited to the value described above so long as cleanliness of the gas is insured. In some cases the heat processing can be carried out more effectively in a vacuum for integrity of the process. It is needless to say that also the temperature and processing time may be specified to optimal values according to the object or condition. Then, the Si layer not reacted yet and remaining on the utmost surface thereon was removed with an etching liquid (e.g., a mixed aqueous liquid comprising fluoric acid and nitric acid) and the silicide layer was exposed. Si may be removed by generating Cl radicals in $Cl_2$ atmosphere. This processing is executed to completely eliminate the possibility for the Si layer to be left there, and if the Si layer has completely been converted to silicide, the etching processing as described above is not necessary (Refer to Fig. 1(b)).

Furthermore a silicide layer exposed to the outside was transported in a ultra-high purity N2 atmosphere and an electric material was formed by using a ultra-high degree vacuum sputtering film forming device. In this embodiment, the Ta layer was formed with a thickness of around 500 nm. Patetrning was executed to the Ta layer 108 as well as to the silicide layer 107, and a lead electrdoe was formed. It is needless to say that any electrode material other than Ta may be used, and also that the thickness is not always limited to the value described above (Refer to Fig.1 (c)).

Fig. 2 shows a result of measurement of the contact resistance of the $TaSi_2/n^+$-Si formed according to the manufacturing process as instructed in the present invention. It is understood from this figure that the resistance value and a range of dispersion are smaller as compared to those in the example of the conventional texhnology (shown in Fig. 11). Fig. 3 shows a result of measurement on an impurities density distribution in the depth direction for the $TaSi^2/n^+$-Si junction formed in the manufacturing process according to the present embodiment by means of the secondary ion mass spectrometry (SIMS). As fa as oxygen is concerned, the density is less than a limit value for measurement in portions other than the surface. Existence of oxygen is observed because a oxide film is formed on the surface in a period of time from a timepoint when the material is transported into the SIMS unit until measurement is started.

From this result, it can easily be understood that, with the method according to the present invention, it is possible to completely prevent intrusion of oxygen when a junction section between an electrode and a semicnductor is formed, and that reduction of mixed contaminants is every effective in reduction of the resistance value in a process for forming an electrode of a semiconductor device.

Also this figure shows that a density of As is high in a section close to an interface with the silicide.

Description of the present invention above assumed formation of an electrode on an n-type high density Si layer, but this embdiment can similarly be applied to formation of an electrode on a p-type high density Si layer. In that case, however, a p-type high density impurities layer is formed as the high density layer 103. As a specied of ions to be implanted, impurities (such as $B^+$ ions or $BF_2^+$ ions or the like) belonging to the same type as the high density layer 103 on the wafer are implanted. For instance, when B ions are used, the ion energy is in a range from 16 to 25 KeV. In some cases other types of ions (such as Si, or Ta ions) may be used.

As described above, with the present invention, it is possible to further reduce the contact resistance, for instance, between an electrode material layer and a semiconductor in a semiconductor device. As a result, performance of a ULSI can further be enhanced.

(Embodiment 2)

Description is made for a second embodiment according to the present invention with reference to Fig.4. In this embodiment, ion implantation for ion mixing and that for forming a high density layer on a semiconductor are simultaneously carried out by implanting ions through a semiconductor layer formed on a metal layer. In Fig.4 (a),the same conditions as those in the wafer according to Embodiment 1 are satisfied except the fact that a high density layer 103 is not formed thereon.

Ion implantation was carried out to a wafer having the construction shown in Fig.4 (a). As a species of ions to be implanted, As ions to become an n-type dopant was implanted. Also P or Sb ions may be used for the same purpose. The implanted dose rate was set, for instance, to 2 x $10^{15}cm^{-2}$, and an acceleration energy for ions was set, for instance, to 75 keV.

After ion implantation, heat processing was executed to form a silicide layer ($TaSi_2$) 407 and again crystalize the ion-implanted layer. As a method of heat processing, an electric furnace was used, and annealing was executed for 1 hour under a temperature of 500°C flowing Ar gas at a rate of 2 l/min (Refer to Fig.4(b)). The method of heat processing as well as conditions are the same as those in Embodiment 1.

Then, the Si layer not reacted yet and remaining on the utmost surface thereon was removed with an etching liquid such as a mixed aqueous liquid comprising fluoric acid and nitric acid and the silicide layer was exposed in high purity inert gas atmosphere, for instance, in Ar atmosphere. Further, as an electrode material, for instance, the Ta layer 408 was formed with a thickness of around 500 nm on the silicide layer without being exposed to atmospheric air. Patterning was executed to the Ta layer 408 as well as to the silicide layer 407 to form a lead electrode (Refer to Fig.4(c)). It is needless to say that any electrode material other than Ta may be used, and also that the thickness is not always limited to the value described above.

Fig.5 shows a result of measurement of current-voltage characteristics in a pn-diode having n+ Si/pSi construction comprising $TaSi_2$ as an electrode formed through the manufacturing process described above. As shown in Fig. 5, it is understood that better quality of diode characteristics can be obtained. This result,as described in Embodiment 1, is casued by completely reducing mixed contaminants such as oxygen at formation of a junction, and by the effect due to the method of forming a junction according to the present invention.

Description of the present embodiment above was assumed that formation of an n-type high density Si layler and of an electrode was made, but this embodiment can similarly be applied to formation of a p-type high density Si layer and of an electrode. In that case, however, as a species of ions to be implanted, ions to become a p-type dopant are used (e.g. B ions).

(Embodiment 3)

Description is made for a third embodiment according to the present invention on formation of a silicide/silicon junction having a very shallow junction with reference to Fig. 6.

The reference numeral 601 indicates a p-type silicon on a wafer surface. A Si layer 601 may be a silicon layer formed on the wafer, or may be silicon wafer itself. Also some portions of the surface of Si layer 601 may be covered with an insulating layer or a metal layer, or a diffused layer in which impurities are added to some portions of the Si layer 601 may be formed. The specific resistance of the Si layer is, for instance, in a range from 0.3 to 1.0 Ω · cm. For the Si layer 601, an n-type may be used if required for a specific purpose. Also, as for the specific resistance, it may not be limited to the range described above according to the purpose or conditions. Formed on the Si layer 601 is an insulating film such as $Sio_2$ film 602 having a thickness of around 500 nm. At least one opening section 603 is provided on the $SiO_2$ film 602. On the film, a metal reacted on a silicon and generating a silicide, for instance, a Ta layer 604 is formed with a thickness of around 10 nm. The thickness may be thinner or thicker than this value described above, but when it is taken into considerations that a silicide layer is required to be uniformly formed or to prevent defects generated in accordance with change of volume at formation of a silicide as much as possible, an optimal thickness should be around 10 nm. And furhtermore on the film, a Si layer 605 including impurities with extremely low density in which specific resistance is,for instance, in a range from 0.01 to 10 kΩ · cm is formed with a thickness of around 30 nm. The thickness of the Si layer 605 is not always limited to 30 nm, but when it is taken into considerations that the surface of the Ta layer 604 is completely covered with the Si layer 605 or the entire Ta layer 604 is completely converted to silicide, the thickness of around 25 nm or more may be enough (Refer to Fig. 6(a)).

Heat processing was carried out to form a silicide layer ($TaSi_2$) 606. As a method of heat processing, an electric furnace was used, and annealing was executed for 1 hour under a temperature of 700°C flowing Ar gas at a rate of 2 l/min. Heating may be executed with a lamp or according to any other method. The gas available for this purpose is not limited to Ar, and such gases as $H_2$, $N_2$, He or a mixture thereof may be used according to a particular purpose or under specific conditions, and also the flow rate is not always limited to the value described above so long as cleanliness of the gas is insured. In some cases the heat processing can be carried out more effectively in a vacuum. It is needless to say that also the temperature and processing time may be specified to optimal values according to the object or condition.

After formation of silicide, the depth of the junction $x_j$to the utmost surface of the silicon in the initial stage before the silicide layer was reacted was measured to obtain a value of 12 nm (Refer to Fig. 6 (b)). In addition, the silicide layer formed by the conventional type of method in which the Si layer 605 was not formed was measured in the same way as described above, the depth of the junction was 22 nm.

It is understood from this result that the junction depth has achieved success with a value as shallow as around 50 % from the surface. It is indispensable that a junction depth is made to the utmost shallowness to manufacture high performance as well as high integration semiconductor element. It is obvious from the embodiment that the method of forming a silicide electrode according to the present invention is very effective to this requirement.

(Embodiment 4)

Fig. 7 is a cross-sectional view showing a manufacturing process for forming a multi-layered wiring construction which is a forth embodiment according to the present invention.

The reference numeral 701 indicates a semiconductor on a wafer surface. Herein a p-type silicon layer is used as an example. A Si layer 701 may be a silicon layer formed on the wafer or may be a silicon wafer itself. Also some portions of the surface of Si layer 701 may be covered with an insulating layer or a metal layer, or a diffused layer to which impulities are added may be provided on some portions of the Si layer 701. The specific resistance of Si layer is, for instance, in a range from 0.3 to 1.0 Ω · cm. The specific resistanc is not always limited to the range described above according to a specific purpose or specific conditions. Formed on the Si layer 701 is, for instance, a $SiO_2$ layer 702 as an insulating film layer, and at least one opening sections 703 to expose the Si layer 701 is formed on a portion of the $SiO_2$ layer 702. A metal layer (e.g., a Ti layer herein) 704 is formed with a thickness of around 10 nm so that the opening section 703 is covered therewith. The thickness may be thinner or thicker than this value described above, but when it is taken into considerations that a silicide layer is uniformly formed or generation of detects in a crystal is prevented as much as possible at formation of silicide, an optimalthickness is around 10 nm. an optimal fil thickness is around 10 nm. And furthermore on the film, a Si layer 705 including implurities having extremely low density in which the specific resistance is, for instance, in a range from 0.01 to 10 kΩ · cm is formed with a thickness of around 18 nm. The thickness of the Si layer 705 is not always limited to 18 nm, but may be dicided in consideration that the surface of the Ti layer 704 should completely be covered with the Si layer 705, and after heat processing, at minimum 1 atom layer or more of the Si layer which is not yet reacted on a metal should be left and the thickness of the unreacted Si layer should not be too thick. Herein the thickness is set to a value thicker than the Ti layer 704, for instance, to around 18 nm. Then, patterning is executed to the Ti layer 704 and Si layer 705 to an appropriate shape (Refer to Fig.7 (a)).

Then heat processing was executed thereto. As a method of heat processing, an electric furnace was used, and annealing was executed for 1 hour under a temperature of 700°C flowing Ar gas at a rate of 2 l/min. Heating may be executed with a lamp or according to any other method. The gas available for this purpose is not limited to Ar, and such gases as $H_2$, $N_2$, He or a mixture thereof may be used according to a particular purpose or under specific conditions, and also the flow rate is not always limited to the value described above. In some cases the heat processing can be carried out more effectively in a vacuum. It is needless to say that also the temperature and processing time may be specified to optimal values according to the object or conditions. With this heat processing, Ti was reacted on Si to form a titan silicide layer ($TiSi_2$) 706 having a thickness of around 25 nm. The junction depth of the titan silicide layer to the Si layer 701 is around 12.5 nm, which indicates that the atmost shallow depth in the junction can be achieved. Also the film thickness of the Si layer 705 not reacted yet was around 5nm (Refer to Fig. 7 (b)).

As an interlayer insulating layer to electrically insulate between wirings, for instance, a $SiO_2$ layer 707 was formed with a thickness from 500 nm to 1 μm by using a method of chemical-vapor deposition (CVD). At least one opening section 708 to expose the unreacted Si layer 705 on the silsicide layer 706 is provided on a portion of the interlayer insulating layer 707 by means of reactive ion etching for the interlayer insulating film after a photolithography process (Refer to Fig. 7 (c)).

After washing the opening section 708 with ultra pure water including ozon of several ppm, the oxicide film on the surface of Si layer 705 was removed by using a hydrofluoric acid aqueous solution diluted by 0.5 to 1 %. Then a metal layer 709, for instance a Ti layer is formed with a thickness of 500 nm so that the opening section 708 is covered therewith. The metal layer 709 may be other metals such as Ta and Pt so long as it is a metal for reacting on silicon under the stable conditions to form a silicide compound. The film thickness may be set to a film thickness so that it completely reacts on the Si layer 705 exposed to the opening section 708, and the entire contact section between the metal layer 709 and silicide layer 706 is converted to silicide. Washing is not limited to the method used in the embodiment so long as conditions that washing is sufficiently effective to the opening 708, and at the same time the Si layer exposed to the opening section 708 is not completely eliminated, and the Si surface exposed to the opening section 708 can be kept at an ultra clean state without any remainder of the passivity film on the surface of Si layer are satisfied (Refer to Fig. 7 (d)).

Then, heat processing is executed to form a silicide layer 710 anew. Heating is similar to the conditions already described above in the embodiment. Finally, patterning was executed to at least a portion or more of a Ti layer 711 in a given form to manufacture wiring construction (Refer to Fig. 7 (e)).

With the method of forming a multi-layered wiring construction according to the embodiment, it has been achieved that a metal surface is prevented from oxidizing by covering the metal surface with silicon and mixed oxygen in the interface with the metal layer is completely suppressed at the formation of a contact section between metallic wirings. Further, when the opening section is washed immediately before forming a metallic wiring on the contact section, it becomes possible to wash with an acid solution, by using a method of covering the metal surface with Si, which could not be used to the opening section in the contact of which metal surface was exposed, and for this reason ultra cleaning of the contact interface can be achieved, whicn makes it possible to improve reliablity of the contact section between metallic wirings. Furthermore, conventionally, an interlayer insulating film, mainly $SiO_2$ was formed on the metal surface so that the film was directly contacted with the surface thereof, so that there have been some problems that electrical characteristics such as electric resistance due to oxidation of a metal surface and electromigration resistance deteriorate, or adhesion between a metal and an oxide film does not work well, but in the embodiment, the metal surface has not been oxidized because an insulating film is formed on the silicide layer in a state where the silicon layer is left thereon, and also adhesion has been improved because $SiO_2$ is formed on the silicon layer which is solidly left on the silicide. It is an object of this example to reduce contact resistance between multi-layered metallic wirings. In Fig.7, description was made for an example in which a metal layer 709 formed on the Si layer 705 was Ti and was formed on the entire surface thereof, but it is quite effective to reduce the resistance if a selective film of tungsten (W) using $WF_6$ and $SiH_4$ for the purpose of surface flatness is formed only on the Si layer of the opening section 708 to form $WSi_2$ by reacting on the Si layer 705.

Multi-layered metallic wiring is used for various purposes in a very high speed microprocessor. If a metal surface is exposed to the atmospheric air, the surface thereof is instantly oxidized and an oxide film having a thickness of 2 to 5 nm is formed thereon. For this reason, contact resistance between a metal and a metal becomes inevitably larger, which makes high speed characteristics of a microprocessor deteriorate, and also makes a logic amplitude smaller. A process as shown in Fig.14 is effective to prevent oxidation of the metal surface. Herein, description is made for an example in which selective growth of W using WF6' SiH4 for the purpose of selective filling into contact holes is used.

Al metallic wiring (around 0.5 to 1 μm) 1402 in a first layer and a non-dope Si layer (around 5 to 10 nm) 1403 are continuously formed on an interlayer insulating film 1401. It is desirable that an interlayer insulating film 1404 is continuously formed by a cluster tool, but the non-dope Si 1503 may be formed by tansporting through the atmospheric air after the surface thereof is terminated with hydrogen because the non-dope Si 1403 is hardly oxidized. Then holes are opened in the interlayer insulating film 1404 according to a specified pattern by a photolithography process. In this step, although the surface of an Al alloy is exposed to the atmospheric air, the surface is not oxidized due to existance of the non-dope Si.

W 1405 is selectively formed only on the non-dope Si in the contact hole section by a $WF_6$ + $SiH_4$ based selective CVD (around 180°C), the non-dope Si 1403 is all reacted on W by the heat processing under a temperature from 400 to 450°C to be converted to $WSi_2$. As described above, the $WSi_2$ linkages between W and Al, and contact between the W and the Al alloy without any oxcide film between them is realized.

Further, the contact with the Al 1406 on the W 1405 is executed so that an oxide film does not exist thereon, and for this reason the contact with no oxide film between them can be realized in the entire contact portions in the multi-layered wiring construction. In a case where an Al alloy thin film 1406 can be formed by using a cluster tool without being exposed to the atmospheric air, as shown in Fig.14, the Al alloy thin film 1406 is directly formed on the surface of the formed W 1405, so that an interface into which oxygnen is less mixed can be formed. Herein, in place of W and Al, metals such as Ta, Ti, Cu, Al, Ag or the like, or alloys thereof may be used. Also this method may be used for any of the layers in the multi-layered wiring construction.

In a case where a device such as a cluster tool is not used, as shown in Fig. 15, by forming a non-dope Si layer 1408 on the W 1405, it is possible to realize a multi-layered wiring construction in which an oxcide film does not exist on the interface. Namely, by transporting the non-dope Si through the atmospheric air after the formation thereof to form an Al alloy thin film 1406, an interface in which an oxcide film does not exist between wirings can be manufactured because the non-dope Si is hardly oxidized. Also, to further enhance oxidizing resistance, the surface may be terminated with hydrogen after the formation of non-dope Si.

It is possible to continuously form the non-dope Si 1408 by using, for instance, a CVD device for forming the W 1405. Namely, the W 1405 is formed by using WF6 and $SiH_4$ gases, subsequently the $WF_6$ gas is stopped, and the non-dope Si 1408 may be formed by using only $SiH_4$. After the Al alloy thin film 1406 is processed, a non-dope Si remaining on the insulating film 1404 is normally removed, but in some cases, the non-dope Si is not required to be removed because of high resistance. On the other hand, it is possible to selectively form a non-dope Si 1408 only on the W 1405, and in this case, the construction shown in Fig. 16 is obtained after processing the Al alloy thin film 1406, and a non-dope Si is not formed on the insulating film 1404. In this case also, as described above, the formation of the non-dope Si 1408 and W 1405 can continuously be carried out in the same CVD device.

On an Al alloy thin film 1406 in a second layer, a non-dope Si thin film 1407 is continuously formed. By forming the non-dope Si film on the Al-alloy thin film as described above, especially by terminating the surface of the non-dope Si film with hydrogen, W selective growth with $WF_6$ + $SiH_4$ is completely carried out, which is quite effective to obtain the surface flatness. It is needless to say that pure Al, Cu, Ag may be used in place of the Al-alloy.

(Embodiment 5)

Fig. 8 is a cross-sectional view showing a manufacturing method of an ohmic contact electrode as well as wiring construction with a semiconductor and a metal component by means of formation of a silicide which is a fifth embodiment according to the present invention.

The reference numeral 801 indicates a semiconductor layer. Herein, an n-type silcon layer is used as an example. A p-type may be used according to a specific purpose. A Si layer 801 may be a silicon layer formed on the wafer, or may be a silicon wafer itself. Also, some portions of the surface of Si layer 801 may be covered with an insulating layer or a metal layer, a diffused layer into which impurities are added may be formed in some portions of the Si layer 801. The specific resistance of the Si layer is, for instance, in a range from 0.3 to 1.0 Ω · cm. Also, the specific resistance is not limited to the range described above according to particular purposes or under specific conditions.

As an insulating film layer, for instance, a $SiO_2$ layer 802 is formed on the Si layer 801, and at least one opening section 803 to expose the Si layer is formed partially

on the $SiO_2$ layer 802. A metal layer, for instance, a Ti layer 804 is formed with a thickness of around 10nm on the substantially entire surface of wafer so that the opening section 803 is covered therewith. A metal such as Ta, Co, W, etc., or other metal may be used for the metal layer 804 so long as it is a metal which reacts on silicon under stable conditions to form a silicide compound.

However, it is required that a solution for etching the metal described above is an etching solution so that etching reaction of the metal on the silicide does not occur quickly, namely, a ratio of the etching reaction of the metal to the etching reaction of the silicide can largely be set. In a case of dry etching is similar to that described above. The thickness may be thinner or thicker than this value, but when it is taken into considerations that a silicide layer should uniformly be formed, or generation of crystal defects should be prevented as much as possible at the formation of a silicide, an optimal thickness of the film is in a range from 5 to 10 nm.

Further on top of the film, a Si layer 805 including impurities having extremely low density of which specific resistance is, for instance, in a range from 0.01 to 10 kΩ · cm is formed with a thickness of around 8 to 13 nm, and patterning is executed in a given form to at least one portion of the film. The thickness of Si layer 805 may not be limited to a value from 8 to 13 nm, but in the embodiment, when it is taken into considerations that the surface of Ti layer 804 is completely covered with the Si layer 805, and the entire Si layer 805 is converted to slicide, it has been set to a range from around 8 to 13 nm (Refer to Fig.8 (a)).

Ion implantation was carried out to a wafer having the structure shown in Fig. 8(a). As a species of ions to be implanted, for instance, As ions to become an n-type dopant were implanted thereto. Also P or Sb ions may be used for the same purpose. In the embodiment, although ions to be an n-tpye dopant are implanted to manufacture an ohmic contact electrode as well as wiring construction, in a case where the purpose is only to convert it to silicide, other ions (e.g.,Si, Ti) may be used. The implanted dose rate is, for instance, $2 \times 10^{15}$ $cm^{-2}$, and an acceleration energy for ions was set, for instance, to 75 keV. In this embodiment, mixing with ion implantation was used to accelerate silicide reaction, ion implantation is not always required to be carried out.

After ion implantation, heat processing was executed to form a silicide layer ($TiSi_2$) and again crystalize the ion-implanted layer. As a method of heat processing, an electric furnace was used, and annealing was executed for 3 hours under a temperature of 450°C flowing Ar gas at a rate of 21/min. Heating may be executed with a lamp or according to any other method. Also the gas available for this purpose is not limited to Ar, and such gases as $H_2$, $N_2$, He or the like, or a mixture thereof may be used according to a particular purpose or specific conditions, also the flow rate is not always limited to the value described above.

In some cases the heat processing can be carried out more effectively in a vacuum. It is needless to say that also the temperature and processing time may be specified to optimal values according to the object or condition. With this heat processing, only Ti near the portion covered with the Si layer 805 was reacted on silicon, and a titan silicide ($TiSi_2$) 806 was formed with a thickness of around 12 to 25 nm. Ti in other portion not covered with the Si layer 805 was left in an unreacted state. The implanted As is activated as a dopant by the heat processing, an n-type high density layer 807 was formed around the silicide layer 806 (Refer to Fig. 8(b)).

Then, this wafer was immersed in an aqueous solution (25°C) mixed with $NH_4OH$, $H_2O_2$, and $H_2O$ at a ratio of volume of 5 to 1 to 1. The mixed ratio of the solution may be other ratio of, for instance, 4 to 1 to 1. A temperature of the solution is not limited to 25°C, but if a temperature of the liquid is too high, it causes $H_2O_2$ to decompose or to vaporize, reversely, if the liquid temperature is too low, it causes an reacting speed to drop, and for this reason, it was set to 25°C herein. By being immersed in this aqueous solution, a Ti layer not reacted yet was etched to be eliminated and the surface of $SiO_2$ layer 802 was exposed. On the other hand, the portion on which $TiSi_2$ was formed was left without being etched, and a titan silicide ($TiSi_2$) electrode for an ohmic contact with Si and the lead wiring construction were formed (Refer to Fig. 8(c)). In this embodiment, the method related to $TiSi_2$ is described, but in a case where other metal, for instance, Co is used, an aqueous solution mixed with, for instance, HCl, $H_2O_2$, and $H_2O$ may be used for etching after the formation of silicide.

Patterning by dry etching process is essential to form an ultra minute construction. But in a case where dry etching is difficult to be carried out like a CuSi, a method of wet etching is effective. Namely, a silicon layer which is patterned in a specified shape is formed on a metal having a high melting point. It is easy to carry out a minute patterning to a silicon by using dry etching.Then heat processing is added thereto, or ion mixing may be executed before the heat processing, but a silicide layer is formed on the entire metal layer having a high mleting point. Only the portion of the metal having a high melting point contacted with the silicon becomes a silicide, so that a width of the formed silicide is substantially equal to a width of the previously patterned silicon layer. After this step, only the silicide is left by selectively wet-etching only to an unreacted metal having a high melting point, which makes it possible to manufacture a minute construction such as an electrode or wiring in a specified shape (Refer to Fig. 8 (d)).

(Embodiment 6)

Fig. 9 is a cross-sectional view showing a sixth embodiment according to the present invention. This embodiment comprises a semiconductor layer having an extremely shallow depth for junction, and an electrode construction made with a compound from a semiconductor and a metal component, and at the same time can form the electrode as well as wiring construction each having a given film thickness.

The reference numeral 901 indicates a semiconductor layer. Herein, a silicon wafer is used as an example. Some portions of the surface of a Si layer 901 may be covered with an insulating layer or a metal layer, a diffused layer to which impurities are added may be formed on some portions of the Si layer 901.

Formed on the Si layer is, for instance, a $SiO_2$ layer as an insulating film layer. On a portion of the surface of wafer, an $n^+$ high density layer 903 in which a density of n-type impurities is, for instance, in a range from 1 to 2 x $10^{20}$ $cm^{-3}$ is formed, and at least one opening section 904 is provided in the $SiO_2$ 902 so that a portion of an area in the high density layer 903 can electrically communicated to the outside.

On the insulating film layer 902, a metal layer, herein, for instance, a Ta layer 905-1 is formed with a thickness of around 10 nm on the substantially entire surface of the wafer thereof. Other metals such as Ti, W, and Pt may be used for the metal layer 905-1 so long as it reacts on a silicon under stable conditions to form a silicide compound. The thickness may be thinner or thicker than this value, but when it is taken into considerations that a silicide layer is uniformly formed, or generation of crystal defects is prevented as much as possible at the formation of silicide, an optimal film thickness is in a range from 5 to 10 nm.

Further on top of the film, a Si layer 906-1 including impurities having extremely low density in which specific resistance is, for instance, in a range from 0.01 to 10 kΩ · cm is formed with a thickness of around 22 nm. Although the thickness of the Si layer 906-1 is not limited to 22 nm, in this embodiment, when it was taken into considerations that the surface of the Ta layer 905-1 was completely covered with the Si layer 906-1, or the entire Si layer 906-1 was converted to silicide, the thickness thereof was set to around 22 nm herein.

Then ion implantation was carried out. As a species of ions to be implanted, for instance, As ions which become an n-type dopant were implanted. P or Sb ions may be used for the same purpose. The implanted doze rate was set to, for instance, 2 x $10^{15}$ $cm^{-2}$, and an acceleration energy for ions was set to, for isntance, 75 keV (Refer to Fig. 9(a)).

Formed on the Si layer 906-1 is a metal layer, herein, for instance, a Ta layer 905-2 with a thickness of around 10 nm on the substantially entire wafer thereof. In some cases, other metal may be used for a metal layer 905-2, but it is optimal that a material thereof is the same as the metal layer 905-1. The thickness may be thinner or thicker than this value, but when it is taken into considerations that a silicide layer is uniformly formed, or generation of crystal defects are prevented as much as possible at the formation of silicide, an optimal film thickness is in a range from 5 to 10 nm. Further on the film, a Si layer 906-2 including impurities having extremely low density in which specific resistance is, for instance in a range from 0.01 to 10 kΩ · cm is formed with a thickness of around 22 nm. Although the thickness of the Si layer 906-2 is not limited to 22nm, in this embodiment, when it was taken into considerations that the surface of the Ta layer 905-2 was completely covered with the Si layer 906-2, or the entire Si layer 906-2 was converted to silicide, it was set to, for instance, around 22 nm herein (Refer to Fig. 9(b)).

From this step on, formation of a metal layer and formation of a silicon layer thereon may be repeated a given number of times in consideration of a thickness of a silicide layer to be formed, but in this embodiment, this process was further repeated twice, and finally, for instance, 4 layers comprising a metal layer and a silicon layer in pairs were formed. The reference numerals 905-3 and 905-4 each indicate a Ta layer, and the reference numerals 906-3 and 906-4 each indicate a Si layer (Refer to Fig. 9(c)).

Then heat processing was carried out. A method and conditions are the same as those for the heat processing discribed in Embodiment 1. A tantalum silicide layer 907 was formed with a thickness of around 96 nm by heat processing. In this embodiment, 4 layers comprising a metal layer and a silicon layer in pairs were formed with the thickness of 96 nm, but by controlling a number of times to form a layer, a film thickness of the silicide layer can comparatively freely be controlled. Also in this embodiment, the heat processing was carried out once after the final film was formed, but, if after the Si layer 906-2 is formed,the heat processing may be carried out a given number of times at least more than 1 time at any point of time. If after the Si layer 906-2 is formed, ion implantation may be carried out any number of times at any point of time. After the silicide layer 907 was formed, patterning was executed in a given shape to form an electrode as well as wiring construction (Refer to Fig. 9(d)).

With this method, a contact electrode having a very shallow junction between a silicide and a silicon was formed. As described in Embodiment 1, as a result of achievement of high performance in a contact forming process, a density of dopant became maximum on the interface thereof, and at the same time, contamination thereof with oxygen was completely reduced, consequently, it has been possible to realize a very low contact resistance value.

It is also desirable that a film thickness of metal in a contact section is as thin as possible to suppress stress strain due to heat stress at formation of a silicide, or crystal defects generated due to a difference between lattice constants. However, when wiring resistance or disconnection is taken into considerations, it is desirable that a film thickness of metal is as thick as possible to form simultaneously a contact electrode and a lead wiring by converting the film to silicide. if the manufacturing method described in this embodiment is used, generation of crystal defects can completely be suppressed, and a contact electrode and a lead wiring construction can simultaneously be formed by using a silicide layer having a certain thickness, and at the same time, the electrical characteristics are satisfactory, and in addition intrusion of a silicide generated by the formation of silicide into a silicon layer can be realized deeply or extremely shallowly. For this reason, the manufacture of a semiconductor device according to the present invention is very effective to realize a high performance ULSI.

INDUSTRIAL AVAILABILITY

With the present invention, it becomes possible to form a metal electrode having a very low contact resistance, and achieve the junction having an extremely shallow depth, and also to realize an ultra high density, ultra high performance, and high reliability ULSI.

## Claims

1. A manufacture of a semiconductor device, wherein at least one layer of a metal layer and a semiconductor layer is continuously formed without being exposed to atmospheric air on at least one portion of a surface of the semiconductor, then heat processing is carried out and said metal layer is reacted on said semiconductor layer to form a compound from a metal component and a semiconductor

2. The manufacture of semiconductor device according to Claim 1, wherein before said heat processing, specified atoms or morecules of impurities are ion-implanted into said semiconductor through said semiconductor layer and metal layer.

3. The manufacture of semiconductor device according to Claim 2, wherein said ions are elements constituting said semiconductor, or atoms generating electrons or holes in said semiconductor, or molecules including the atoms.

4. The manufacture of semiconductor device according to Claim 3, wherein impulities are ion-implanted into said semiconductor so that a density of impulities in said semiconductor becomes maximum level on an interface between said semiconductor and said compound.

5. The manufacture of semiconductor device according to any of Claims 2 to 4, wherein an implanted dose rate of said ions is in a range from $1 \times 10^{13}$ to $4 \times 10^{18}$ $cm^{-2}$.

6. The manufacture of semiconductor device according to any of Claims 1 to 5, wherein said semiconductor is a silicon (Si) semiconductor.

7. The manufacture of semiconductor device according to any of Claims 1 to 6, wherein said metal layer is a metal having a high melting point, an alloy including a metal having a high melting point, or a compound formed from metals having a high melting point.

8. The manufacture of semiconductor device according to Claim 7, wherein said metal layer includes at least one type of metal among Ta, Ti, W, Co, Mo, Hf, Ni, Zr, Cr, V, Pd, and Pt.

9. The manufacture of semiconductor device according to any of Claims 1 to 8, wherein a thickness of said metal is in a range from 1 to 50 nm.

10. The manufacture of semiconductor device according to any of Claims 1 to 9, wherein a density of impurities in said semiconductor layer is $1 \times 10^{18}$ $cm^{-3}$ or less.

11. The manufacture of semiconductor device according to any of Claims 1 to 10, wherein a thickness of said semiconductor layer is 0.3 nm or more.

12. The manufacture of semiconductor device according to Claim 11, wherein the thickness of said semiconductor layer is set to more than that of said metal layer, and the interface between said compound and said semiconductor is made shallower.

13. The manufacture of semiconductor device according to Claim 11 or 12, wherein more than a half portion of the thickness of said compound formed after said heat processing is carried out is positioned at the side of said semiconductor layer.

14. The manufacture of semiconductor device according to any of Claims 1 to 13, wherein said semiconductor layer comprises a silicon (Si) semiconductor.

15. The manufacture of semiconductor device according to any of Claims 1 to 14, wherein, after said heat processing,and in a case where the semiconductor layer not reacted yet is not left, a second metal layer is continuously formed thereon.

16. The manufacture of semiconductor device according to any of Claims 1 to 14, wherein, after said heat processing, the semiconductor layer not reacted yet is removed, and the second metal layer is formed.

17. The manufacture of semiconductor device according to any of Claims 1 to 14, wherein, after said heat processing, the second metal layer is formed on the semiconductor layer not reacted yet, then the heat processing is carried out to form a compound from said unreacted semiconductor layer and the metal of second metal layer.

18. The manufacture of semiconductor device, wherein after a metal layer and a semiconductor layer are continuously formed on a substrate without being exposed to the atmocpheric air, patterning is executed to said semiconductor layer in a specified shape, then heat processing is carried out to form a compound from a metal and a semiconductor by reacting said metal layer on said semiconductor layer, and after the step, the metal not reacted yet is removed by etching to form a compound from a metal and a semiconductor to a specified shape.

**19.** A semiconductor device manufactured by the manufacturing method of a semiconductor device according to any of Claims 1 to 18.

**20.** A semiconductor device in which a compound from said semiconductor and metal is formed in a contact section between the semiconductor and electrode, wherein a depth of an interface between said compound and said semiconductor is made shallower than 22 nm.

**21.** A semiconductor device in which a compound from said semiconductor and metal is formed in the contact section between the semiconductor and electrode, wherein a depth of an interface between said compound and said semiconductor is made less than 12 nm.

**22.** A semiconductor device in which a compound from said semiconductor and metal is formed in the contact section between the semiconductor and electrode, wherein more than a half portion of the thickness of said compound is positioned at the upper side of the surface of said semiconductor.

**23.** A semiconductor device comprising a multi-layered metallic wiring construction, wherein a contact section connecting the upper metallic wiring to the lower one has a thin silicide layer.

Fig. 1

(a)

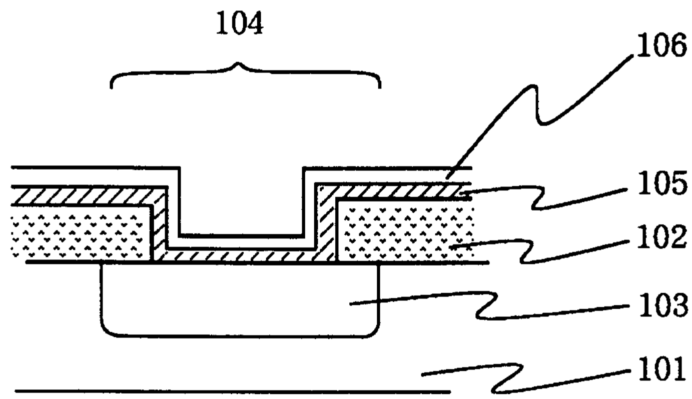


(b)

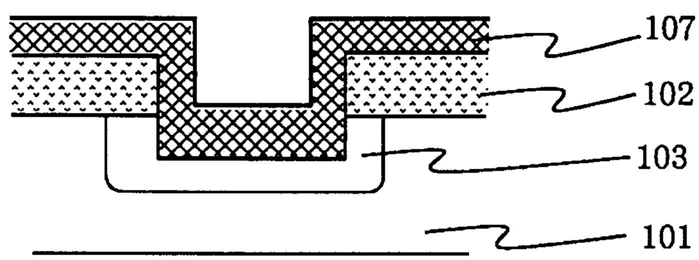


(c)

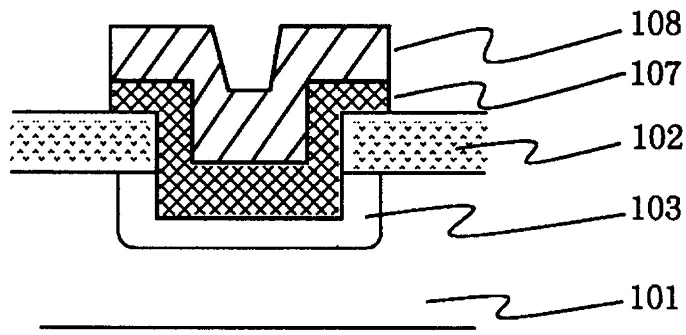

F i g. 2

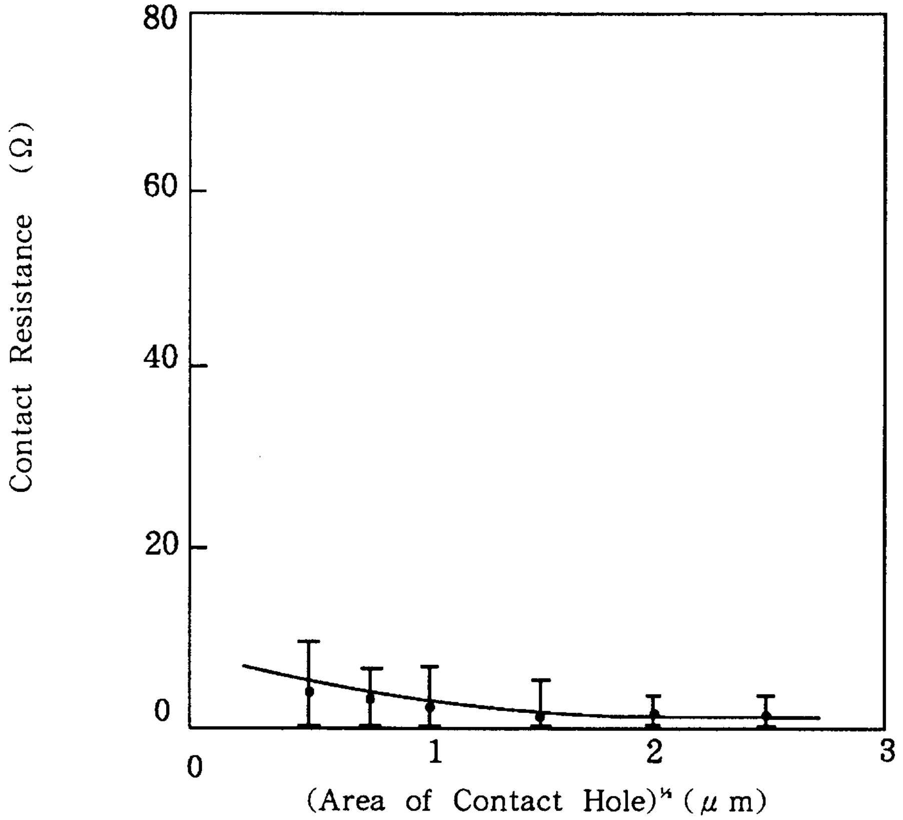
80
60
40
20
0
Contact Resistance (Ω)
0
1
2
3
(Area of Contact Hole)½ (μ m)

F i g. 3

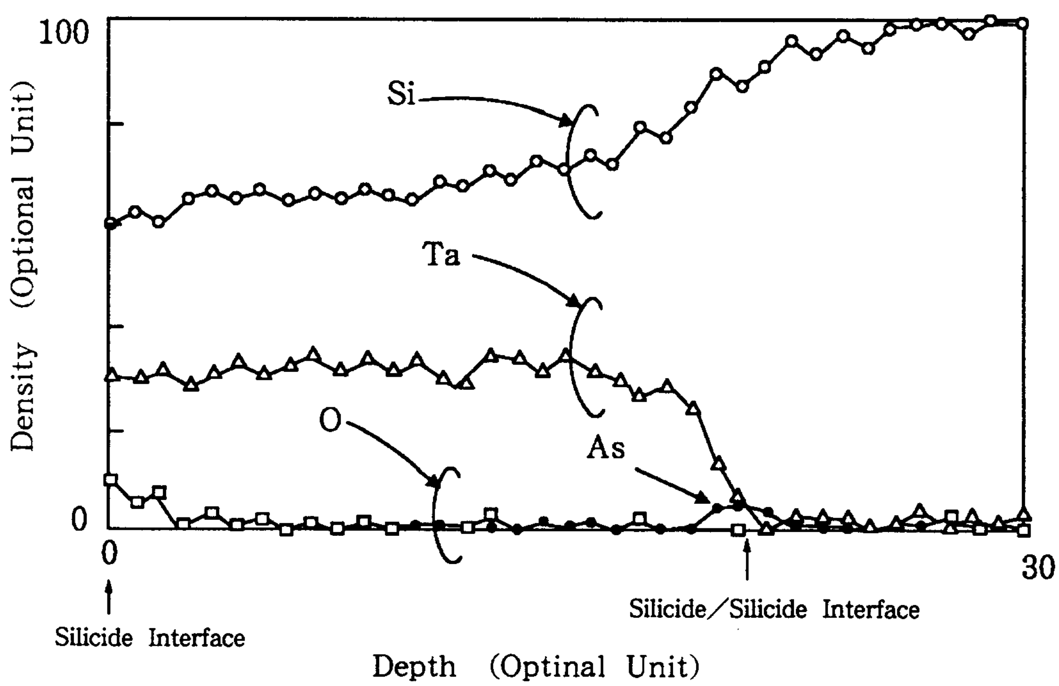
100
0
Si
Ta
O
As
Density (Optional Unit)
0
30
Silicide Interface
Silicide／Silicide Interface
Depth (Optinal Unit)

Fig. 4

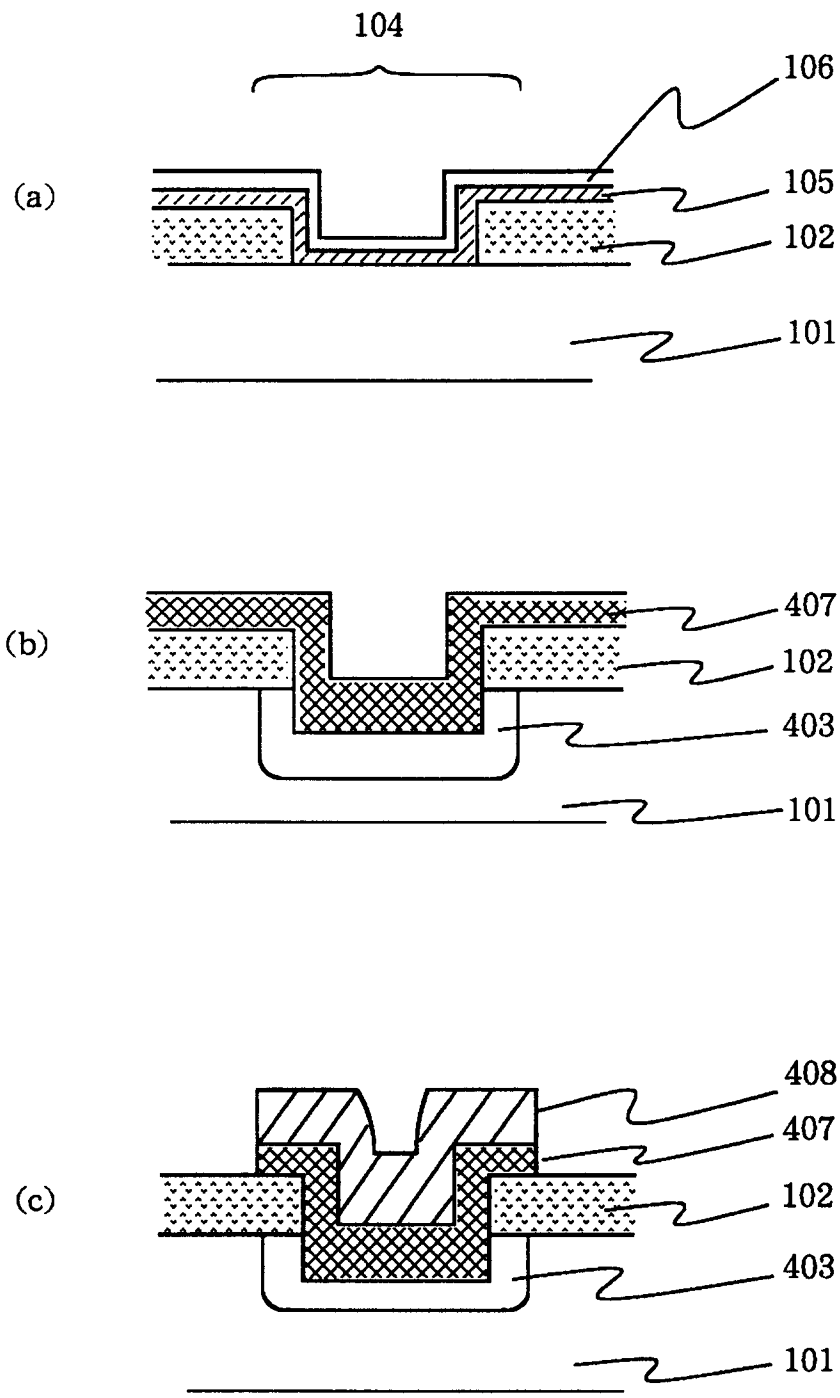

Fig. 5

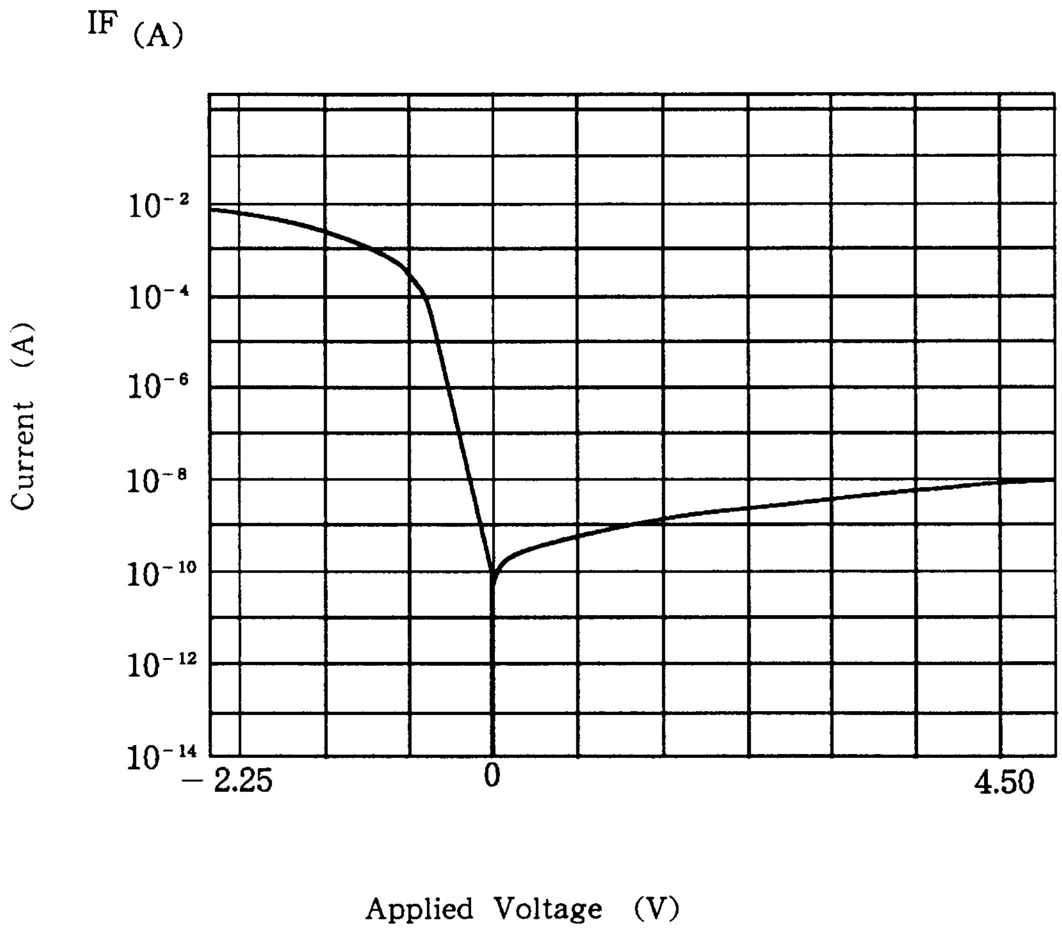
IF (A)
Current (A)
10⁻²
10⁻⁴
10⁻⁶
10⁻⁸
10⁻¹⁰
10⁻¹²
10⁻¹⁴
− 2.25
0
4.50
Applied Voltage (V)

Fig. 6

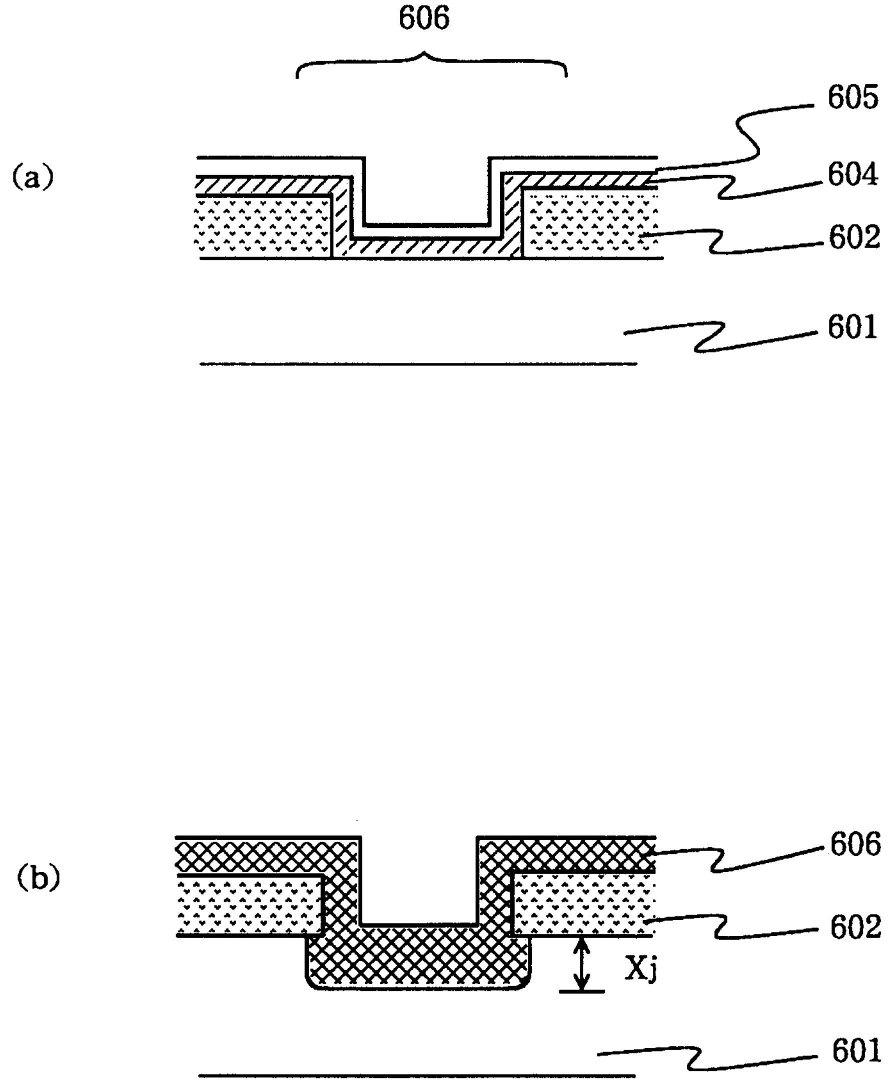

Fig. 7

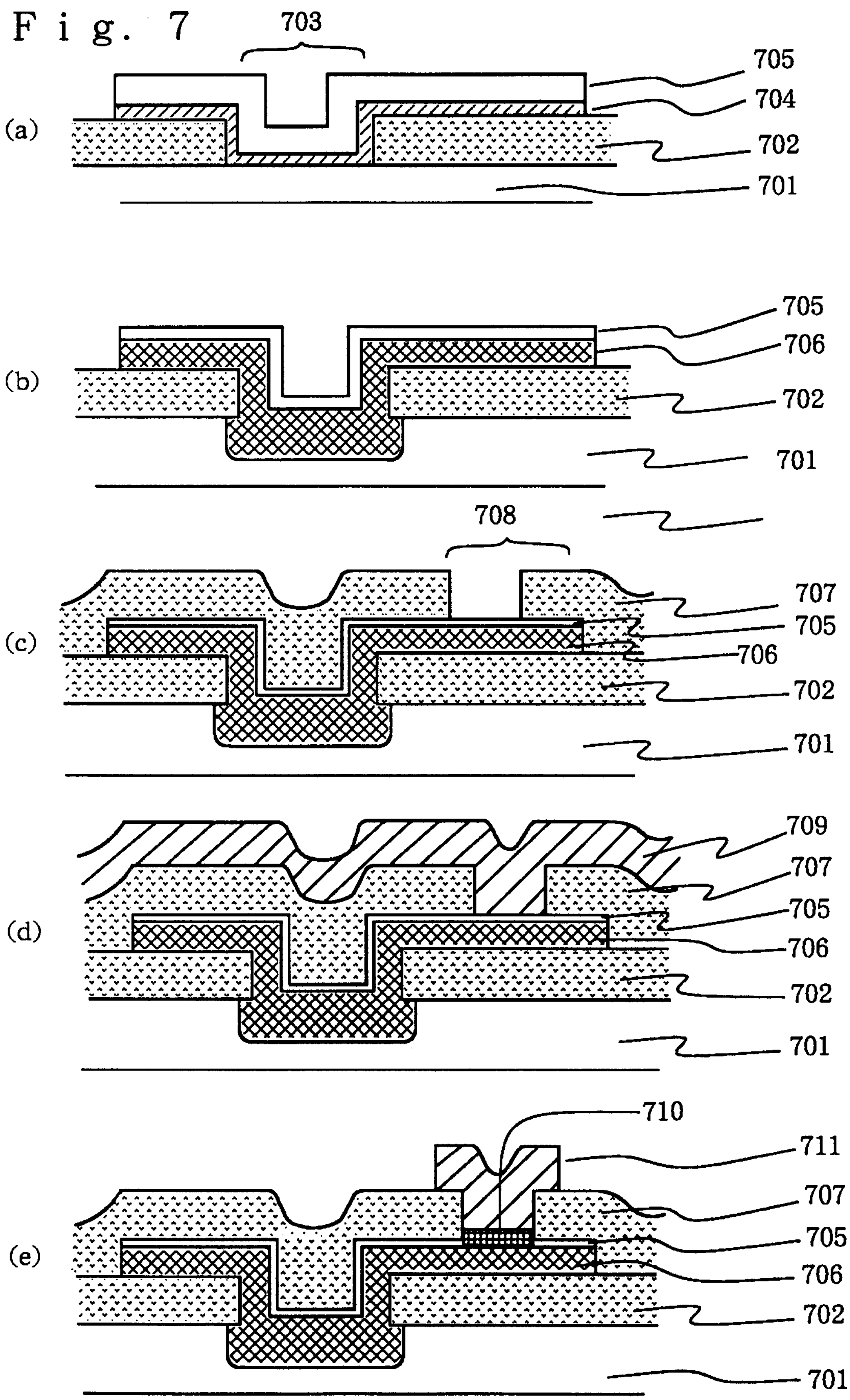
703
705
704
(a)
702
701
705
706
(b)
702
701
708
707
705
(c)
706
702
701
709
707
705
(d)
706
702
701
710
711
707
705
(e)
706
702
701

Fig. 8

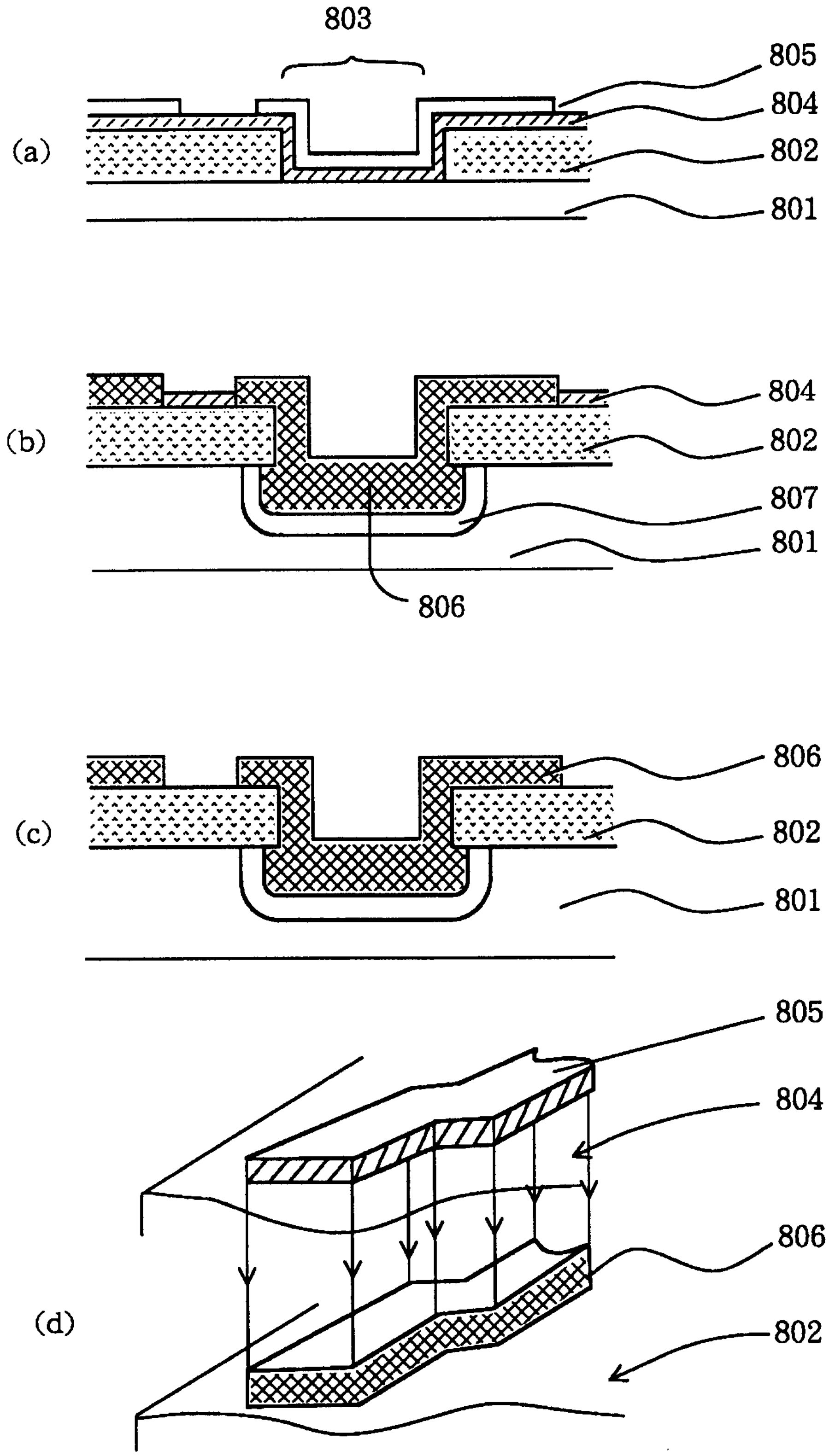
803
805
804
(a)
802
801
804
(b)
802
807
801
806
806
(c)
802
801
805
804
806
(d)
802

Fig. 9

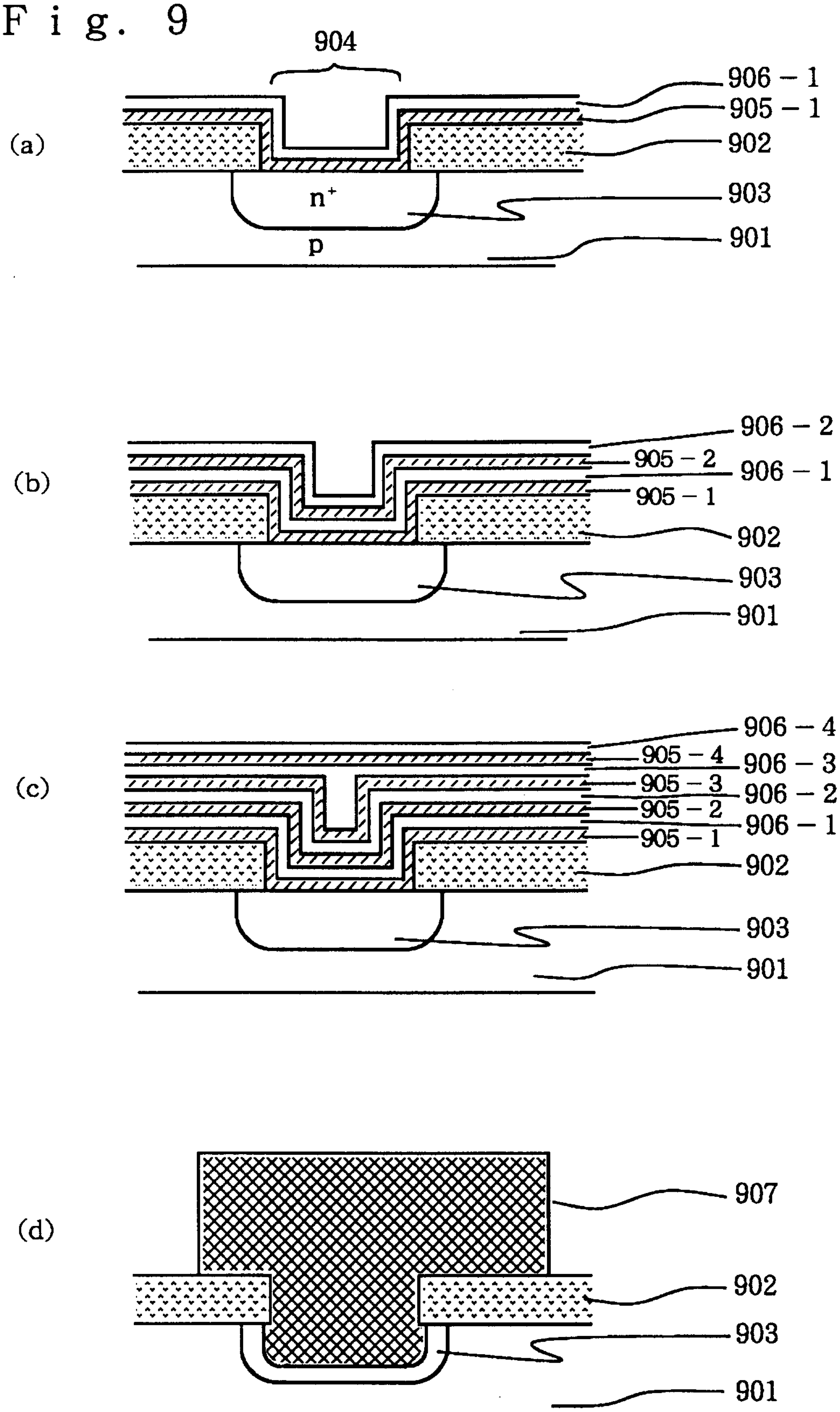
904
906 − 1
905 − 1
(a)
902
n+
903
p
901
906 − 2
905 − 2
906 − 1
(b)
905 − 1
902
903
901
906 − 4
905 − 4
906 − 3
(c)
905 − 3
906 − 2
905 − 2
906 − 1
905 − 1
902
903
901
907
(d)
902
903
901

Fig. 10

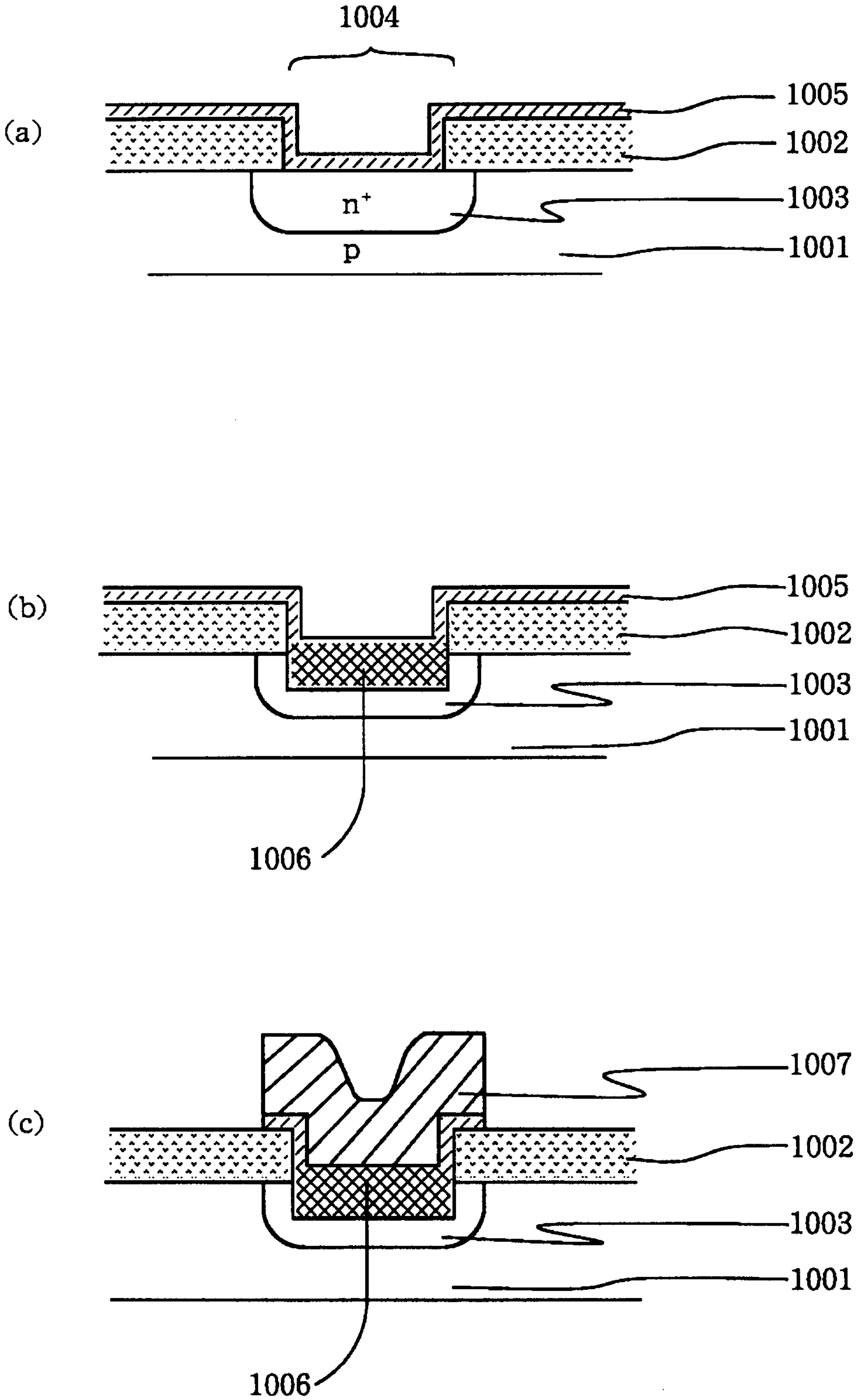
1004
(a)
1005
1002
n+
1003
p
1001
(b)
1005
1002
1003
1001
1006
(c)
1007
1002
1003
1001
1006

Fig. 11

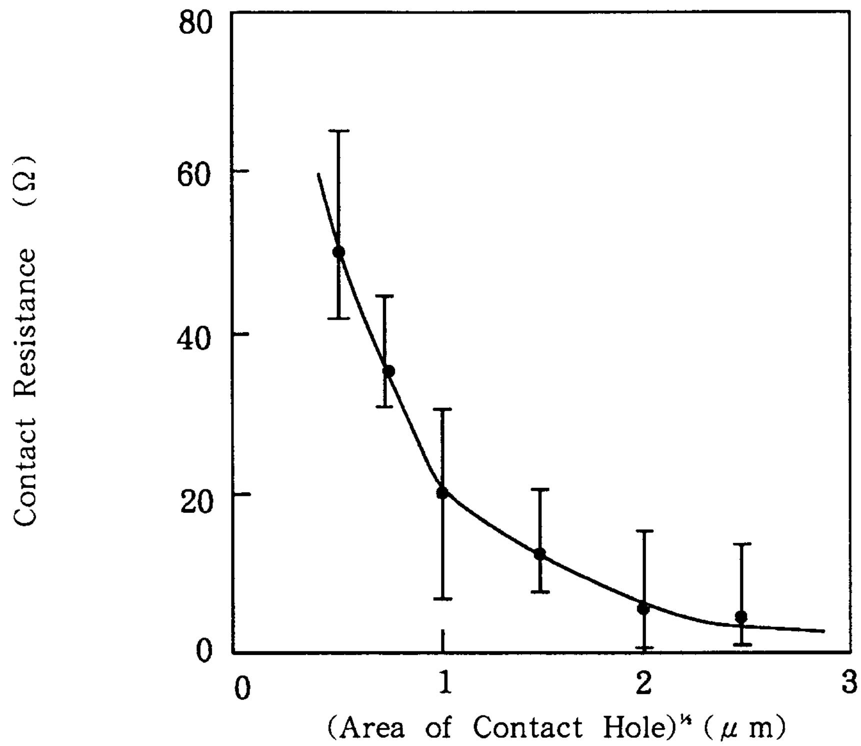
80
60
40
20
0
0
1
2
3
Contact Resistance (Ω)
(Area of Contact Hole)½ (μ m)

Fig. 12

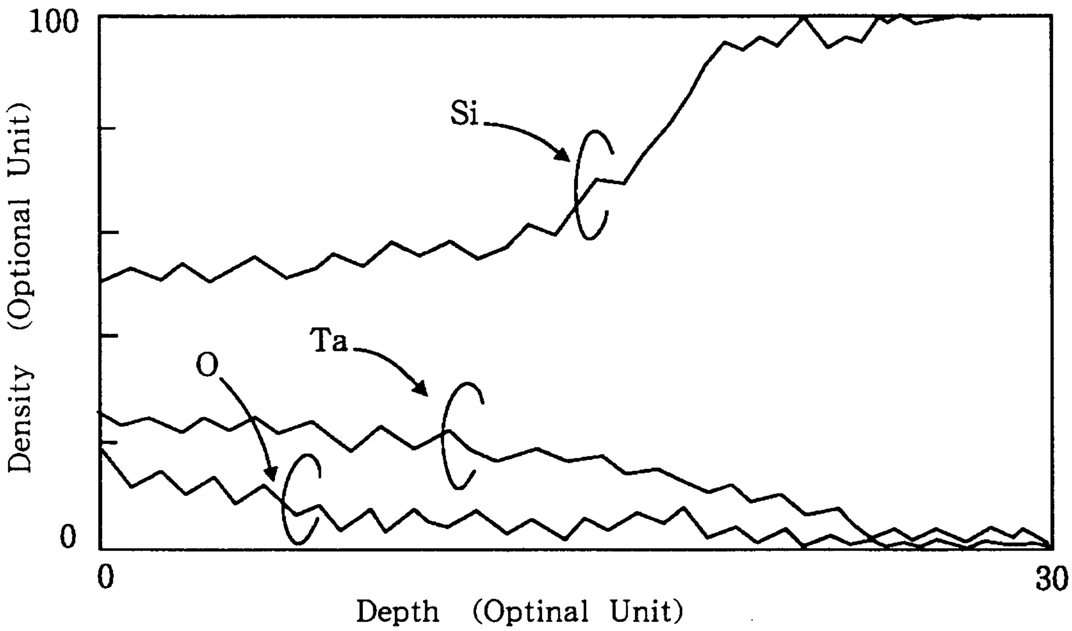
100
0
0
30
Si
Ta
O
Density (Optional Unit)
Depth (Optinal Unit)

Fig. 13

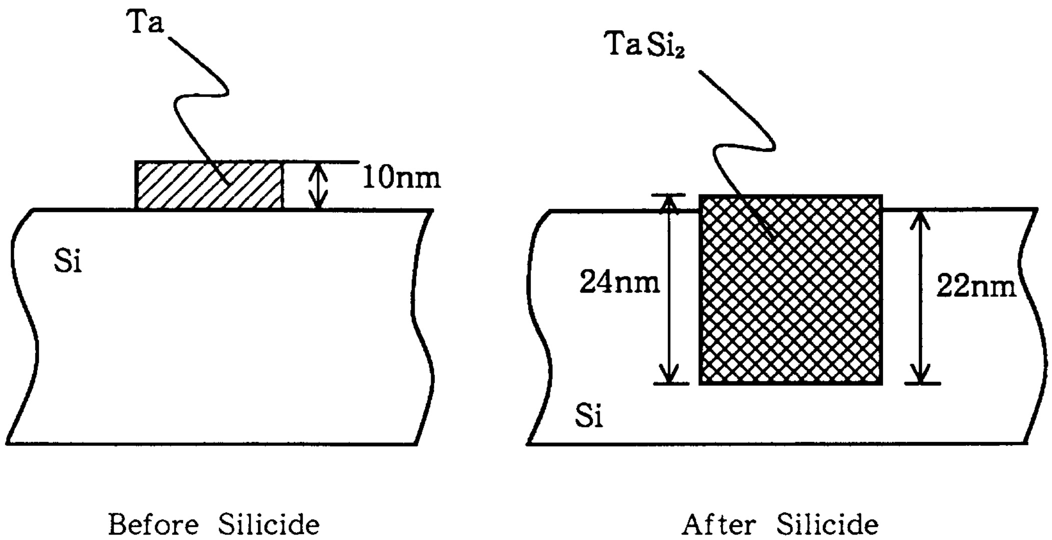
Ta
10nm
Si
Before Silicide
$TaSi_2$
24nm
22nm
Si
After Silicide

Fig. 14

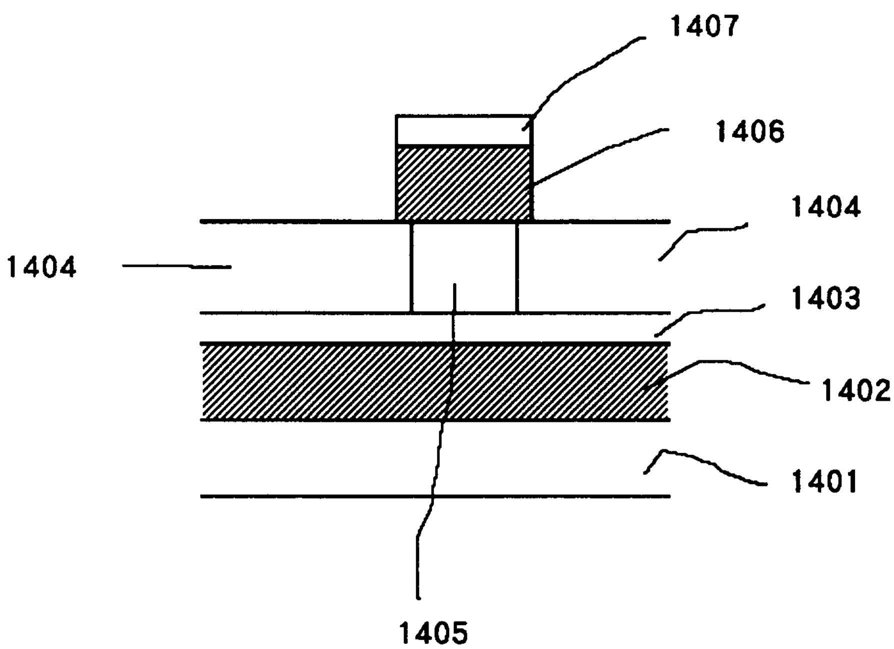
1407
1406
1404
1404
1403
1402
1401
1405

Fig. 15

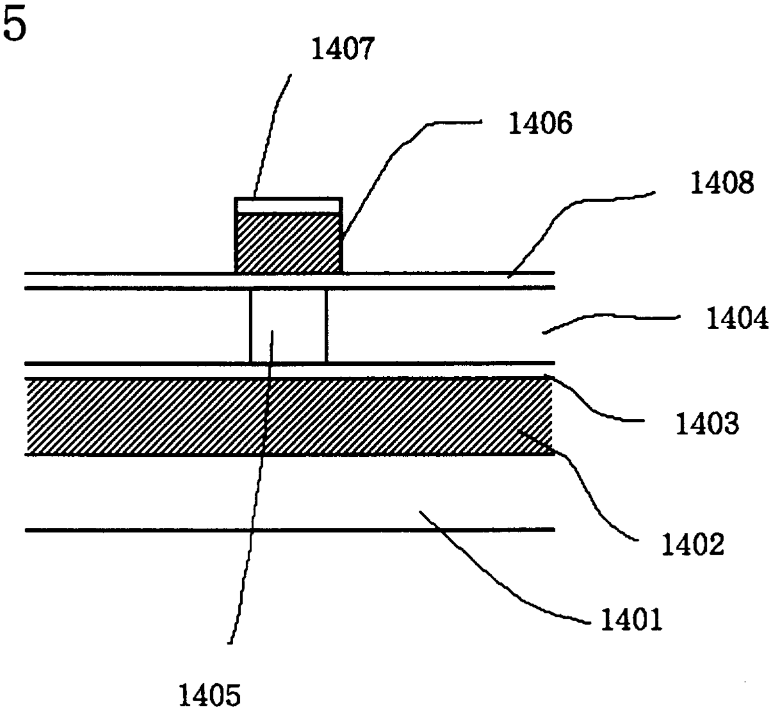
1407
1406
1408
1404
1403
1402
1401
1405

Fig. 16

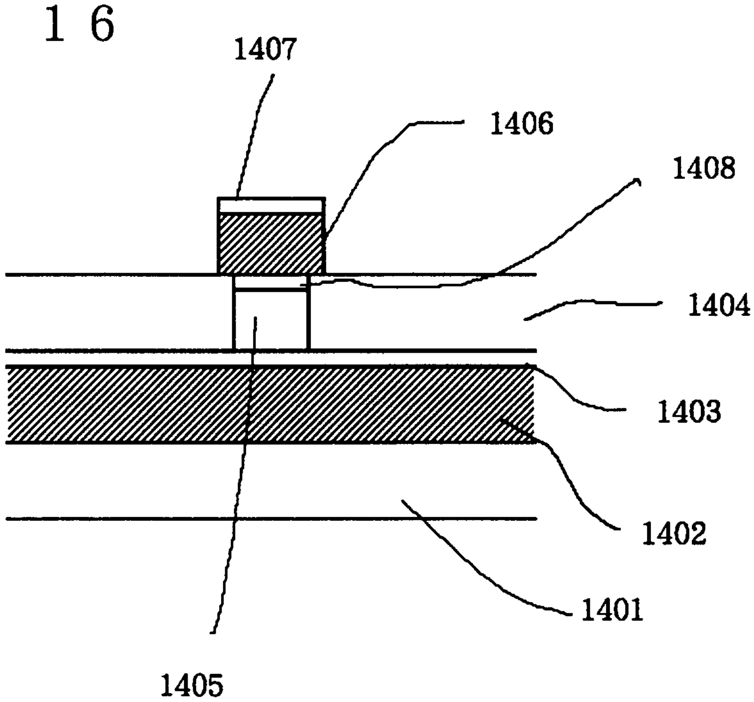
1407
1406
1408
1404
1403
1402
1401
1405

REPORT

International application No. PCT/JP94/01373

A. CLASSIFICATION OF SUBJECT MATTER

Int. $Cl^6$ H01L21/28

According to International Patent Classification (IPC) or to both national classification and IPC

B. FIELDS SEARCHED

Minimum documentation searched (classification system followed by classification symbols)

Int. $Cl^5$ H01L21/28

Documentation searched other than minimum documentation to the extent that such documents are included in the fields searched

Jitsuyo Shinan Koho 1964 - 1994
Kokai Jitsuyo Shinan Koho 1971 - 1994

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP, A, 62-7165 (Hitachi, Ltd.), January 14, 1987 (14. 01. 87), (Family: none) | 1-23 |
| Y | JP, A, 2-5521 (Fujitsu Ltd.), January 10, 1990 (10. 01. 90), (Family: none) | 1-19 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| December 1, 1994 (01. 12. 94) | December 27, 1994 (27. 12. 94) |
| Name and mailing address of the ISA/ Japanese Patent Office | Authorized officer |
| Facsimile No. | Telephone No. |

Form PCT/ISA/210 (second sheet) (July 1992)